Europäisches Patentamt

European Patent Office

Office européen des brevets

(19)

(11) **EP 0 508 359 B1**

(12) **EUROPÄISCHE PATENTSCHRIFT**

(45) Veröffentlichungstag und Bekanntmachung des Hinweises auf die Patenterteilung:
**09.10.1996 Patentblatt 1996/41**

(51) Int Cl.6: **C23C 14/34**, C23C 14/54, H01J 37/34

(21) Anmeldenummer: **92105963.0**

(22) Anmeldetag: **07.04.1992**

(54) **Verfahren und Anlage zur Beschichtung mindestens eines Gegenstandes**

Process and apparatus for coating at least one object

Procédé et dispositif pour le revêtement d'au moins un objet

(84) Benannte Vertragsstaaten:
**AT BE CH DE DK ES FR GB IT LI LU NL SE**

(30) Priorität: **12.04.1991 CH 1095/91**

(43) Veröffentlichungstag der Anmeldung:
**14.10.1992 Patentblatt 1992/42**

(73) Patentinhaber: **BALZERS AKTIENGESELLSCHAFT FL-9496 Balzers (LI)**

(72) Erfinder: **Kuegler, Eduard, Dr. Dipl.-Ing. A-6807 Feldkirch-Tisis (AT)**

(74) Vertreter: **Troesch Scheidegger Werner AG Patentanwälte, Siewerdtstrasse 95, Postfach 8050 Zürich (CH)**

(56) Entgegenhaltungen:
**EP-A- 0 328 257        EP-A- 0 416 241**

- **PATENT ABSTRACTS OF JAPAN vol. 12, no. 353 (C-530)(3200) 21. September 1988, &JP-A-63 111 173**
- **SURFACE AND COATINGS TECHNOLOGY Bd. 33, 1987, AMSTERDAM Seiten 405 - 423;**
- **SCHILLER ET AL.: 'Reactive DC high-rate sputtering as production technology'**
- **JOURNAL OF VACUUM SCIENCE AND TECHNOLOGY: PART A. Bd. 6, Nr. 3, Juni 1988, NEW YORK US Seiten 1845 - 1848; ESTE ET AL.: 'A quasi-direct-current sputtering technique for the deposition of dielectrics at enhanced rates'**
- **Thin Solid Films, Vol. 101 (1983) March, No.1, Elsevier Sequoia, Lausanne, Switzerland; pages 1-5: "Effect of N2-Ar Mixing on the Reactive Sputtering Characteristics of Silicon", T. Serikawa et al.**

Bemerkungen:
Die Akte enthält technische Angaben, die nach dem Eingang der Anmeldung eingereicht wurden und die nicht in dieser Patentschrift enthalten sind.

## Beschreibung

Die vorliegende Erfindung betrifft ein Verfahren nach dem Oberbegriff von Anspruch 1 sowie eine Anlage hierfür nach dem Oberbegriff von Anspruch 21.

Aus dem Artikel "Deposition of Tantalum and Tantalum Oxide by Superimposed RF and DC Sputtering", F. Vratny, J. Electrochem. Soc.: Solid State Science, May 1967, (1), ist es bekannt, dielektrische Werkstückbeschichtungen durch Hochfrequenzzerstäuben dielektrischer Targetmaterialien in einer Glimmentladung herzustellen.

Im weiteren ist es daraus auch bekannt, metallische Targets zu diesem Zwecke zu zerstäuben, mit Gleichstrom und, dies überlagert, Hochfrequenz, dabei die abgestäubten Teilchen mit einem Gas reagieren zu lassen, um auf dem zu beschichtenden Gegenstand eine dielektrische Schicht zu bilden.

In diesem Artikel, der zum integrierenden Bestandteil der vorliegenden Beschreibung erklärt wird, ist ausgeführt, dass durch Verwendung eines Hochfrequenzanteiles für die Zerstäubung, unter anderem, verhindert wird, dass wegen auf dem metallischen Target sich absetzender Reaktionsprodukte, als isolierende Schicht, Durchschläge und Ueberschläge entstehen, welche den Beschichtungsprozess stören, sei dies durch zeitliche Unregelmässigkeiten oder durch Spritzer, bzw. gar den Zerstäubungsvorgang gänzlich zum Erliegen bringen.

Es wird im erwähnten Artikel (1) erkannt, dass die Beschichtungsrate am Werkstück bei Zerstäuben mit Gleichstrom und überlagertem Hochfrequenzsignal höher ist als bei reiner Gleichstromzerstäubung. Als Hochfrequenz wird eine Frequenz von 13.56MHz eingesetzt.

Bezüglich Beschichtung von Werkstücken mit einer dielektrischen Schicht, durch sogenanntes Hochfrequenz-Magnetronzerstäuben eines dielektrischen Targets, sei auf den Artikel "Magnetron Sputtering of $S_iO_2$; An Alternative to Chemical Vapor Deposition", Karel Urbanek, Solid State Technology, April 1977, (2), hingewiesen. Auch hier wird mit einer Frequenz von 13.56MHz gearbeitet.

Ausführlich sind in der DE-OS-25 13 216 (3) die Probleme, die dann entstehen, wenn eine metallische Targetplatte gleichstromzerstäubt wird und die abgestäubten Teilchen einer Reaktion mit einem Gas, zur Bildung einer dielektrischen Beschichtung, ausgesetzt werden, beschrieben, wie dies bereits im obgenannten Artikel (1) von Vratny erwähnt ist. Es wird in dieser Schrift, die ebenfalls als integrierender Bestandteil der vorliegenden Beschreibung erklärt wird, ausgeführt, dass Hochfrequenz-Wechselstrom für die Zerstäubung eingesetzt wird, wenn ein aus ohmisch nicht leitendem Material bestehendes Target zerstäubt werden soll.

Weiter wird auf die Möglichkeit der Ueberlagerung von Hochfrequenz- und Gleichspannungszerstäubung eingegangen, zur Erhöhung der Zerstäubungsrate auch an einem metallischen bzw. leitenden Target. Dabei wird erläutert, dass auch durch das sogenannte Magnetronzerstäuben die Zerstäubungsrate entsprechend erhöht werden könne. Auch hier wird weiter erläutert, dass das Entstehen von Lichtbogen an mit einer isolierenden Schicht beaufschlagten - vergifteten - Targetbereichen, wie bereits im Artikel (1) ausgeführt, durch Ueberlagerung eines Wechselstromsignals für die Zerstäubung weitgehendst verhindert wird. Es wird mit Frequenzen zwischen 400Hz und 60kHz gearbeitet.

Im Artikel (4), "Reaktives DC-Hochratezerstäuben als Produktionsverfahren" von S. Schiller et al., Vortrag zur International Conference on Metal Coating, San Diego/Cal., März 1987, Surface and Coating Technology 33 (1987), wird ausführlich auf das reaktive Gleichstromzerstäuben zur Beschichtung von Werkstücken eingegangen. Insbesondere ist darin das Hystereseverhalten eines solchen reaktiven Gleichstromzerstäubungs- und Beschichtungsprozesses dargelegt:

Wird ein metallisches Target gleichstrom-(DC)-zerstäubt und der Massestrom des reagierenden Gases zum Glimmentladungsraum zwischen Target und zu beschichtendem Werkstück kontinuierlich erhöht, so steigt der Gas-Partialdruck leicht an bei gleichzeitiger leichter Abnahme der Zerstäubungsrate, wie dies bereits aus (1) bekannt ist. In dieser Anfangsphase ist der Verbrauch des reaktiven Gases fast vollständig und nimmt dann ab, so dass der Partialdruck dieses Gases weit weniger zunimmt als dessen Massefluss, d.h. als die pro Zeiteinheit dem Prozessraum zugeführte Reaktivgasmenge.

In diesem Bereich, Metallmode genannt, ist der reaktive DC-Gleichstromzerstäubungs/Beschichtungsprozess stabil. Bei einem Grenzwert des erwähnten Masseflusses springt der Partialdruck des reaktiven Gases zu einem wesentlich erhöhten Wert. Gleichzeitig springt der Reaktivgasverbrauch sprunghaft auf einen tieferen Wert, die Zerstäubungsrate ihrerseits springt auf einen drastisch reduzierten Wert. Dieser Sprungbereich wird Uebergangsmode genannt. Bei weiterer Erhöhung des Reaktivgasmasseflusses in den Prozessraum folgt der Partialdruck wiederum einer stabilen Kennlinie - dem reaktiven Mode -, ebenso der Reaktivgasverbrauch und die nun wesentlich erniedrigte Zerstäubungsrate. Auf dieses Verhalten bei DC-Zerstäuben wird noch detaillierter eingegangen.

Während bei einem Reaktivgasmassefluss unterhalb des erwähnten kritischen Wertes vom Target im wesentlichen Metallteilchen abgestäubt werden und mit dem reaktiven Gas reagieren, erfolgt, bei Ueberschreiten des erwähnten kritischen Wertes, eine massgebliche Targetvergiftung, d.h. das leitende bzw. metallische Target wird, mindestens abschnittsweise, schlechtleitend bzw. dielektrisch beschichtet, es werden signifikant weniger Metallteilchen abgestäubt, womit weniger Reaktivgas verbraucht wird, dessen Partialdruck mithin massgeblich ansteigt. Die Zerstäubungsrate fällt drastisch. Bei Reduktion des Reaktivgasmasseflusses, ausgehend vom reaktiven Mode, springt der Prozess zurück in den metallischen Mode, jedoch mit deutlichem Hystereseverhalten.

Aus diesem Artikel (4), ebenfalls integrierender Teil der vorliegenden Beschreibung, ist weiter bekannt, dass, wie bereits auch aus Vratny (1) bekannt, die Zerstäubungsrate mit zunehmendem Reaktivgaspartialdruck abnimmt, und weiter der Reaktionsgrad $\gamma = y/x$ der abgeschiedenen Verbindung $Me_xR_y$ mit zunehmendem Reaktionsgaspartialdruck zunimmt.

Es wird in (4) gefolgert, dass man dann, wenn man eine dielektrische Schicht mit hoher Rate abscheiden will, einerseits mit hoher Plasmadichte der DC-Glimmentladung in Werkstücknähe arbeiten soll und in der Regel im Uebergangsmode.

Es werden in (4) nun Massnahmen erörtert, wie der Gleichstromprozess in einem instabilen Bereich, dem erwähnten Uebergangsmode, stabilisiert werden kann, mit Hilfe eines externen, schnellen Regelkreises, insbesondere bei welchem ein Plasmaemissionsmonitor (PEM) als IST-Wert-Aufnehmer und -Umsetzer eingesetzt wird und, als Stellglied, auf ein schnell arbeitendes Ventil zur Stellung des Reaktivgasmasseflusses eingewirkt wird.

Im Artikel (5), "Possibilities of Silicon Oxide Deposition in Vacuum Web Coating", u.a. vom selben Autor S. Schiller, wie vorgenannter Artikel (4), aus 3rd International Conference on Vacuum Web Coating, San Antonio/Texas, November 1989, ist ausführlich erörtert, dass bei reaktivem Gleichstromzerstäuben eines metallischen Targets, bei der Realisierung eines erwünschten hohen Oxidationsgrades der Beschichtung, die Beschichtungsrate derart klein wird, dass an eine industrielle Anwendung kaum zu denken ist. Für die Hochfrequenzzerstäubung eines dielektrischen Targets - eines $SiO_2$-Targets - wird erkannt, dass extrem hohe Hochfrequenzleistungen erforderlich sind, was wiederum so hohe Kosten für entsprechende Fertigungsanlagen mit sich bringe, dass Hochfrequenz-Dioden-Zerstäuben nicht in Frage komme.

Gefolgert wird (5), dass Bemühungen zum Beschichten von Werkstücken mit dielektrischen Schichten - $SiO_x$ -auf Elektronenstrahl-Verdampfungsverfahren dielektrischer Targets gerichtet werden sollten.

Aus der US-A-4 851 095 (6) ist ein Verfahren bekannt, bei welchem, im wesentlichen, weiteren Anweisungen aus dem Artikel (4), "Reaktives DC-Hochratezerstäuben", gefolgt wird, nämlich in einem ersten Arbeitsbereich mit relativ tiefem Reaktivgaspartialdruck, durch DC-Zerstäubung eine Beschichtung auf das Werkstück aufgebracht wird und, in einem zweiten Arbeitsbereich, der aufgrund des erwähnten relativ tiefen Partialdruckes ungenügende, tiefe Reaktionsgrad $\gamma$ der Beschichtung, bei höherem Reaktivgaspartialdruck, nachreagiert wird, bei einem Wert, der, am Zerstäubungsprozess eingesetzt, zu dessen Umkippen in den Reaktivmode führen würde. Hierzu wird das Werkstück durch eine aufwendige schnelle Rotationsbewegung durch die erwähnten Arbeitsbereiche gefahren.

Nebst der aufwendigen mechanischen Konstruktion führt dieses Vorgehen vor allem wegen der starken zeitlichen Stöchiometriewechsel an der wachsenden Schicht zu erheblichen Nachteilen.

Wie schon aus (1), ist es auch aus der EP-A-0 347 567 (7) bekannt, die Zerstäubung mit Gleich- und Hochfrequenzstrom zu betreiben, womit die Grundstabilität eines Prozessarbeitspunktes im Metallmode, d.h. dessen "Abstand" vom Uebergangsmode, erhöht werde. Es wird dabei die elektrische Kathodenspannungs/Kathodenstrom-Kennlinie der Entladung betrachtet.

Auch aus der EP-A-0 416 241 ist es bekannt, die Zerstäubung mit Gleichstrom und überlagertem Hochfrequenzstrom zu betreiben. Dabei wird ein ohmisch leitendes Target in einer Glimmentladung zerstäubt, und die abgestäubten Teilchen werden im Raum zwischen Target und Werkstück mit einem Gas zur Reaktion gebracht und am Werkstück abgelegt. Speziell ausgebildete Targetanordnungen sind beschrieben, um eine Anordnung zur Ausführung eines solchen Verfahrens vermeintlich überhaupt stabil zu betreiben und eine hohe Beschichtungsrate und Schichtqualität zu erreichen.

Die vorliegende Erfindung setzt sich zum Ziel, ausgehend von Verfahren letztgenannter Art, den zu treibenden Konstruktionsaufwand zu reduzieren, dabei die Möglichkeit zu schaffen, den Prozesswirkungsgrad gar zu erhöhen.

Diese Aufgabe wird durch das Verfahren bzw. die Anlage nach dem Wortlaut des Kennzeichens von Anspruch 1 bzw. 21 gelöst.

Durch das erfindungsgemässe Vorgehen, nämlich die Kombination

- Betrieb der Glimmentladung durch Gleichstrom und diesem überlagertem Wechselstrom im angegebenen Frequenzbereich,

- Betrieb des Beschichtungsprozesses im instabilen Uebergangsmode,

werden überraschenderweise nicht oder schlecht leitende Schichten mit hohem Reaktionsgrad $\gamma$ auf Gegenstände abgelegt, mit einem guten Energieausbeuteverhältnis, gegeben durch das abgelegte Schichtvolumen pro eingesetzte Zerstäubungsenergie zu Schichtvolumen einer nicht reaktiv abgelegten Metallschicht pro dazu eingesetzter Zerstäubungsenergie, weiter bei hoher Beschichtungsrate, so dass sich das vorgeschlagene Vorgehen ausgezeichnet für eine kommerzielle Produktion eignet. Dass im Uebergangsmode bei hohem Reaktionsgrad $\gamma$ hohe Beschichtungsraten erzielbar sind, ist vermutlich mit darin begründet, dass, wie gezeigt werden wird, mindestens bei erfindungsgemässem

EP 0 508 359 B1

Vorgehen, der Uebergangsmode von vermuteten, bekannten Verläufen abweicht, indem darin die Zerstäubungsrate bei zunehmendem Massefluss des Reaktionsgases zunimmt, mindestens abschnittsweise, und dabei der Partialdruck des Reaktionsgases, mindestens abschnittsweise, im wesentlichen konstant bleibt.

Mithin wird erreicht:

a) eine mindestens nahezu stöchiometrisch homogene Beschichtung,

b) dies bei hoher Beschichtungsrate und

c) bei möglichst gutem Wirkungsgrad, was zu installierende Zerstäubungsleistung anbelangt, Reaktionsgasausnützung und Anlageaufwand.

In einer höchst bevorzugten Weise wird, nebst nach dem Wortlaut von Anspruch 2, nach demjenigen von Anspruch 3 vorgegangen. Demnach wird bei erfindungsgemässem Ablegen einer Schicht im Uebergangsmode gar eine höhere Energieausbeute erzielt als beim nicht reaktiven Ablegen einer Metallschicht.

Gegenüber der EP-A-0 416 241 wurde erfindungsgemäss erkannt, dass mit der Kombination von Gleichstrom und Wechselstrom im angegebenen Frequenzbereich für die Speisung der Glimmentladung und mit dem Betrieb im Uebergangsmode Probleme, wie sie bekanntlich bei der DC-Zerstäubung auftreten, auch behoben werden.

Durch erfindungsgemässen Betrieb der Glimmentladung mit Gleich- und Wechselstrom wird weiter die Zerstäubungsrate erhöht bzw. der Wirkungsgrad, was angelegte elektrische Leistung bzw. Massefluss des Reaktivgases anbelangt, optimiert. Gleichzeitig wird dadurch aber auch erreicht, dass bereits, und insbesondere, näher am Metallmode, ein hoher Reaktionsgrad $\gamma$ der Beschichtung erreicht wird, dies höchst wirkungsgradoptimal, lediglich durch zusätzliches Aufbringen eines Wechselstromanteils mit einer Leistung von 10 bis 80%, vorzugsweise von 10 bis 50% der Gleichstromleistung.

Wie erwähnt, kann das überraschende Ergebnis, dass erfindungsgemäss homogene stöchiometrische Schichten mit hoher Beschichtungsrate und gutem Wirkungsgrad im Uebergangsmodebetrieb abgelegt werden können, vermutlich dadurch erklärt werden, dass in unerwarteter Art und Weise, mindestens bei erfindungsgemässem Betrieb im genannten Uebergangsmode, die Zerstäubungsrate mit zunehmendem Reaktionsgasmassefluss, mindestens über Bereiche und insbesondere über weite Bereiche, zunimmt, dabei in diesen Bereichen der Partialdruck des Reaktivgases, in Funktion des Reaktivgasmasseflusses, im wesentlichen konstant bleibt.

Insbesondere wird mit dem erfindungsgemässen Verfahren nach dem Wortlaut von Anspruch 2 der Wechselstrom so erzeugt, dass er einen leistungsmässig dominanten Spektralanteil im Mittelfrequenzbereich zwischen 50Hz und 250kHz (je inklusive), dabei besonders bevorzugt zwischen 10kHz und 200kHz (je inklusive) aufweist, wobei insbesondere auch auf die Möglichkeit hingewiesen wird, hierzu Frequenzen in der Grössenordnung von 50Hz bis 500Hz einzusetzen oder gar Frequenzen bis 10Hz. Die erwähnten Frequenzen lassen sich ohne grossen technischen Aufwand bereitstellen, insbesondere mit weit weniger Aufwand als Hochfrequenz.

Die Aussage, dass der dominante Spektralanteil in den angegebenen Frequenzbereichen liege, heisst, dass es durchaus möglich ist, höhere Spektralanteile und/oder tiefere im Wechselstromsignal vorzusehen, wie bei allen Verlaufsverzerrungen von Sinussignalen, bei insbesondere Rechteckimpulsen, gegebenenfalls mit überlagerten, tieferfrequenten Anteilen.

Es wird im weiteren durch Einsatz der Wechsel- und Gleichstromzerstäubung die Hysterese, wie sie aus dem Artikel "Reaktives DC-Hochratezerstäuben" für Gleichstromzerstäubung bekannt ist, zu höheren Reaktivgasmasseflussbereichen hin geschoben, womit sowohl Metallmode wie auch Uebergangsmode in Reaktivgas-Partialdruckbereiche zu liegen kommen, an welchen, gegenüber Gleichstromzerstäuben, erhöhte Reaktionsgrade erzielt werden bei gleichzeitig mindestens gleicher Zerstäubungs- und Beschichtungsrate.

Es zeigt sich weiter, dass der Uebergang von metallischem zu reaktivem Mode, was seine Lage und/oder seinen Verlauf anbelangt, durch das angelegte Wechselstromsignal, dessen Leistung und/oder Frequenz eingestellt werden kann.

Indem nun zusätzlich, gemäss Anspruch 5, ein Arbeitspunkt im an sich instabilen Uebergangsmode, näher näher dem Metallmode, bevorzugterweise durch eine Regelung, stabilisiert wird, wird es nun zusätzlich möglich, einen überraschend hohen Reaktionsgrad bei hoher Zerstäubungs- und damit Beschichtungsrate zu erreichen, bei höherer Zerstäubungsrate als bei Gleichstromzerstäubung erreicht. Der Arbeitspunkt kann gegebenenfalls bis hin zum Reaktivmode eingestellt werden.

Um den Prozessarbeitspunkt auf jedem Punkt der instabilen Kennlinien im wesentlichen unabhängig von dessen Verlauf stabilisieren zu können, und auch gegebenenfalls nahe am Reaktivmode, wird weiter vorgeschlagen, die Regelung vorzugsweise nach dem Wortlaut von Anspruch 7 vorzunehmen. Damit wird verhindert, dass der Arbeitspunkt in den Metall- oder Reaktivmode wegläuft.

Dadurch, dass die Verstärkung des offenen Regelkreises, bei dem bekanntermassen das Uebertragungsverhalten zwischen SOLL-Grössenvorgabe und an die Vergleichseinheit rückgeführter IST-Grösse betrachtet wird, wobei aber die Rückführung zur Vergleichseinheit aufgeschnitten ist, wie in besagtem Anspruch 7 spezifiziert ausgebildet ist, wird sichergestellt, dass der vorgegebene Arbeitspunkt des Prozesses nicht durch arbeitspunktrelevante Störgrössen kurzzeitig und ohne dass derartige Störgrösseneinflüsse rasch ausgeregelt würden, verschoben werden kann und davonläuft. Dadurch wird mithin sichergestellt, dass erfindungsgemäss der Prozessarbeitspunkt stabil festgelegt werden kann.

Es wird, für reines Wechselstromzerstäuben, auf die Modellierung reaktiver Zerstäubungsprozesse von S. Berg et al. in den Artikeln (8, 9), "Modeling of reactive sputtering of compound materials", J.Vac.Sci.Technol. A 5 (2), 1987, und "Process modeling of reactive sputtering", J.Vac.Sci.Technol. A 7 (3), Juni 1989, hingewiesen, welche Schriften, zur Erläuterung des komplexen Prozessverhaltens, zum integrierenden Bestandteil der vorliegenden Beschreibung erklärt werden.

Im weiteren wird auch auf "Patent Abstracts of Japan", Vol. 12, No. 353 (C-530)(3200) 21. September 1988 & JP, A,63 111 173 (ANELVA CORP) 16. Mai 1988 (siehe Zusammenfassung) hingewiesen.

Im weiteren wird bevorzugterweise zur weiteren Erhöhung des Wirkungsgrades vorgeschlagen, das Target magnetronzuzerstäuben, d.h. in bekannter Art und Weise mittels Magnetfeldern die Plasmadichte am Target zu erhöhen.

Mit dem erfindungsgemässen Vorgehen ist es, wie erwähnt wurde, möglich, stöchiometrische Schichten bei Betrieb im Uebergangsmode herzustellen, und dies bei höchst vorteilhaft hoher Beschichtungsrate. Um aber die Beschichtungsrate auch bei einem Reaktionsgrad $\gamma$ viel $<< 1$ zu erhöhen, wird vorgeschlagen, gegebenenfalls nach dem Wortlaut von Anspruch 8 vorzugehen.

Es wurde weiter erkannt, dass beim plasma-unterstützten, reaktiven AC+DC-Zerstäuben eines schlecht leitenden Targets, wie und insbesondere aus Si, das zur, Erhöhung seiner Leitfähigkeit gemäss Anspruch 15 dotiert wird, die Dotierung gemäss Anspruch 17 mit Phosphor eine wesentlich geringere Neigung ergibt, dass am vergifteten Target Ueberschlag- und Spritzer-Erscheinungen auftreten, was an sich erlaubt, mit höheren Leistungen zu arbeiten, ohne in den Reaktiv-Mode zu kippen, als mit anders dotierten Targets.

Die Targets, insbesondere Si-Targets, die bevorzugt eingesetzt werden, weisen weiter vorzugsweise eine Leitfähigkeit von 0,01 bis 100$\Omega$ cm auf, vorzugsweise von 0,01 bis 1$\Omega$ cm, gemäss Anspruch 16.

Ein schnelles Bewegen der Gegenstände bzw. Werkstücke entfällt. Doch kann es günstig sein, eine langsame Bewegung der Werkstücke im Prozess und/oder der noch zu beschreibenden Nachreaktion, z.B. mit einer Umlaufgeschwindigkeit $\leq 1$ Hz, so z.B. von 0,5 Hz, vorzusehen, gemäss Anspruch 11.

Bevorzugte Ausiührungsvarianten des erfindungsgemässen verfahrens zeichnen sich mithin nach den Ansprüchen 2 bis 20 aus, die Beschichtungsanlage sowie bevorzugte Ausführungsvarianten davon nach den Ansprüchen 21 bzw. 22 bis 36.

Durch das Vorgehen nach der vorliegenden Erfindung wird es möglich, die Zerstäubungstechnik für die Herstellung qualitativ höchsten Anforderungen genügender, schlecht leitender bis hin zu dielektrischer Schichten zu nutzen, so für optische Anwendungen, was vormals weitgehendst, wirtschaftlich vertretbar, nur mittels Bedampfungsverfahren möglich war, also mittels Verfahren, die sich für die automatisierte, industrielle Fertigung weit weniger eignen als die Zerstäubungstechnik.

Die Erfindung wird anschliessend beispielsweise anhand von Figuren erläutert.

Es zeigen:

Fig. 1    anhand von qualitativen Prozesskennlinien das erfindungsgemässe Vorgehen,

Fig. 2    eine erfindungsgemässe Anlage, schematisch dargestellt,

Fig. 3a, 3b    ein Blockschaltbild einer erfindungsgemässen Regelung mit dem Amplitudengang des Bode-Diagrammes des offenen Regelkreises, qualitativ,

Fig. 4a    linke Vertikalachse: Si-Intensität, proportional zur Si-Zerstäubungsrate; Horizontalachse: Massefluss des Reaktivgases $O_2$, rechte Vertikalachse: Spannung an Si-Target; Horizontalachse: Massefluss des Reaktivgases $O_2$,

Fig. 4b    linke Vertikalachse: Si-Intensität, proportional zur Si-Zerstäubungsrate; Horizontalachse: Massenfluss des Reaktivgases $O_2$, rechte Vertikalachse: Partialdruck des Reaktivgases $O_2$; Horizontalachse: Massefluss des Reaktivgases $O_2$.

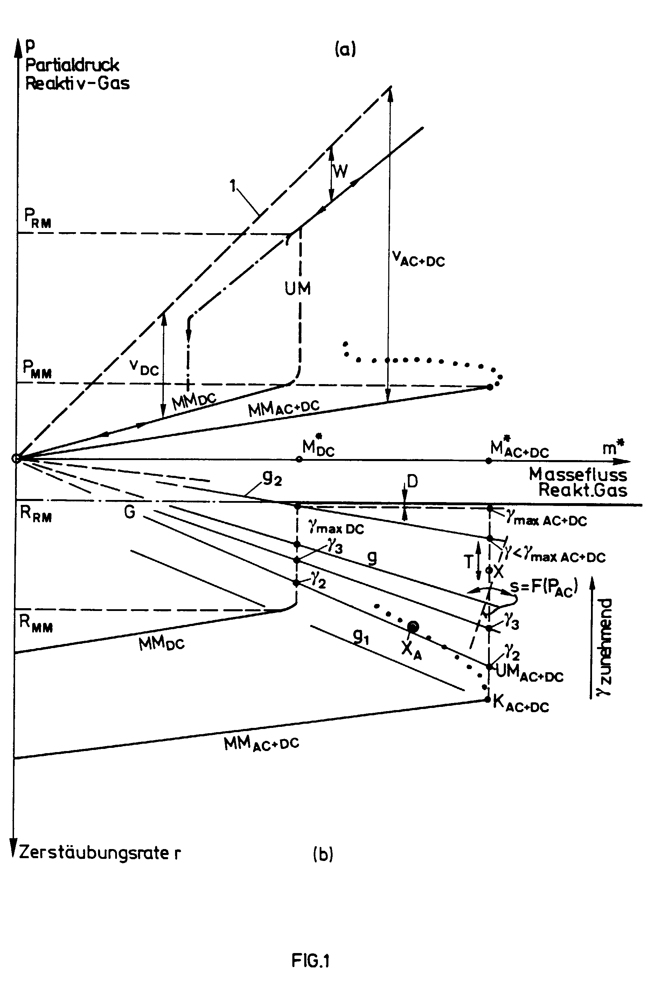

Anhand von Fig. 1 soll vorerst das erfindungsgemässe Vorgehen durch Betrachtungen an rein qualitativ dargestellten Hystereseverläufen eines Beschichtungsprozesses für dielektrische Schichten mit Hilfe reaktiver Zerstäubung eines leitenden bzw. metallischen Targets dargestellt werden. Die Darstellung und auch die nachfolgenden Erläuterungen erheben keinen Anspruch auf wissenschaftliche Exaktheit.

Sie basieren vorerst auf bekannten Verläufen, die bereits einen ersten Einblick ermöglichen. Erst darnach wird auf die überraschend andersartigen Verläufe, die sich bei erfindungsgemässem Vorgehen ergeben, eingegangen, welche dann dem Verständnis der erfindungsgemäss ausgenützten Vorteile mit dienlich sein sollen.

Es soll versucht werden, verständlich zu machen, welche Effekte vermutlich erfindungsgemäss ausgenützt werden, um die nach der Erfindung erzielten Resultate zu ergeben.

In der Darstellung (a) ist über der Achse "Massefluss des Reaktionsgases" m* in den Prozessraum zwischen zerstäubtem Target und Werkstück, der Reaktionsgas-Partialdruck p qualitativ dargestellt. Ohne Unterhalt der Glimmentladung im Prozessraum, d.h. ohne Betreiben des Beschichtungsprozesses, nimmt gemäss der gestrichelten Linie 1 der Partialdruck p in Funktion des Masseflusses m* linear zu. Wird nun, im Reaktionsraum, eine Gleichstrom-Glimmentladung gezündet und das Target gleichstromzerstäubt, so wird bis zu einem kritischen Masseflusswert $M^*_{DC}$ ein Grossteil des zugeführten Reaktionsgases im reaktiven Prozess durch abgestäubte Targetteilchen verbraucht, entsprechend dem Mass $v_{DC}$ gemäss Darstellung (a). Dies führt zur Beschichtung des Werkstückes mit dem dielektrischen Reaktionsprodukt.

Erreicht, beim Gleichstromzerstäuben, der Reaktionsgasmassefluss den erwähnten kritischen Wert $M^*_{DC}$, so springt der Partialdruck vom Wert $P_{MM}$, im metallischen Mode MM, auf den wesentlich höheren Wert $P_{RM}$, im reaktiven Mode RM, und bei weiterer Erhöhung des Reaktionsgasmasseflusses m* steigt der Reaktionsgaspartialdruck auf dem wesentlich erhöhten Niveau weiterhin an. Dieser zweite stabile Betriebsast der Kennlinie ist der reaktive Mode RM. Der instabile, gestrichelt dargestellte Uebergang ist der Uebergangsmode UM.

Im reaktiven Mode wird eine im wesentlichen massefluss-unabhängige Menge Reaktionsgas, entsprechend dem Masse w, durch Reaktion verbraucht, auf dem Target hat sich eine dielektrische Schicht gebildet. Die Schicht auf dem Werkstück bzw. Gegenstand bildet sich im wesentlichen durch Weiterreaktion mit dem Reaktionsgas noch um. Ein eigentlicher Reaktionsprozess findet kaum mehr statt, vom Target werden Reaktionsproduktteilchen abgestäubt. Dieser stabile Bereich RM ist für die Werkstückbeschichtung aufgrund der erwähnten Targetvergiftung, d.h. seiner dielektrischen Abdeckung mindestens für den hier vorgesehenen Zweck nicht oder eben nur sehr unwirtschaftlich ausnützbar.

Strichpunktiert ist quantitativ der Kennlinienverlauf dargestellt, wenn, ausgehend vom reaktiven Mode RM, der Massefluss m* reduziert wird, bis der Prozess in den metallischen Mode MM rückkippt, woraus das typische Hystereseverhalten erkenntlich ist, von dem bis anhin bekanntlich ausgegangen wird.

In Darstellung (b) ist der Verlauf der Zerstäubungsrate r - positive Achse nach unten! - in Funktion des Reaktionsgasmasseflusses m* dargestellt. Mit zunehmendem Massefluss m* nimmt, im metallischen Mode MM, die Zerstäubungsrate r ab, woraus ersichtlich wird, dass der Reaktionsgrad $\gamma$ der zerstäubten Teilchen mit zunehmendem Massefluss zunimmt. Dies, weil die Zerstäubungsrate nach (b) abnimmt und gleichzeitig, nach (a), der Anteil reagierenden Reaktionsgases, entsprechend dem Mass $v_{DC}$, zunimmt.

Beim kritischen Massefluss $M^*_{DC}$ springt die Zerstäubungsrate r von $R_{MM}$, im metallischen Mode, auf einen wesentlich tieferen Wert $R_{RM}$ und bleibt, im Reaktivmode, im wesentlichen konstant. Bei Vergiftung des Targets werden von der sich auf dem metallischen Target gebildeten dielektrischen Schicht Teilchen abgestäubt und am Werkstück angelagert, die im Prozessraum kaum mehr Reaktionsgas konsumieren. Bei vollständiger Targetabdeckung bricht der Gleichstromzerstäubungsprozess im wesentlichen ab.

Bei Betrieb der Glimmentladung und der Zerstäubung mit Gleichstrom und überlagertem Wechselstromanteil relativ geringer Leistung - wesentlich geringer, als dies für die ausschliessliche Wechselstromzerstäubung notwendig wäre - ergibt sich eine signifikante Erhöhung der Zerstäubungsrate r bei gleichem Reaktionsgasmassefluss, damit auch eine entsprechende Erhöhung der Beschichtungsrate.

Dies entspricht in Darstellung (b) dem Verlauf MM(AC+DC). Wenn nun nämlich bei gleichem Reaktionsgasmassefluss m* die Zerstäubungsrate r bei Wechselstromüberlagerung erhöht wird, so wird der reagierende Reaktionsgasanteil höher, womit der Reaktionsgaspartialdruck im metallischen Mode MM(AC+DC) weit weniger mit zunehmendem Massefluss m* ansteigt als im DC-Fall. Der Anteil zugeführten Reaktionsgases, welcher, bei Wechselstromüberlagerung, mit abgestäubten Teilchen reagiert, ist mit $v_{AC+DC}$ in Darstellung (a) eingetragen.

Im wesentlichen ist der im Prozessraum herrschende Reaktionsgaspartialdruck p dafür entscheidend, ob der Prozess vom stabilen metallischen Mode MM, über den Uebergangsmode UM, in den reaktiven Mode RM umkippt. Es wird nun der Partialdruckgrenzwert $P_{MM}$ bei Wechselstromüberlagerung wesentlich später erreicht, d.h. bei einem wesentlich grösseren Reaktionsgasmassefluss $M_{AC+DC}$ als demjenigen, $M_{DC}$, bei reiner Gleichstromzerstäubung.

Daraus ist ersichtlich, dass durch den einen erfindungsgemäss eingesetzten Schritt, nämlich die Zerstäubung mit Gleichstrom plus überlagertem Wechselstrom zu betreiben, eine wesentlich erhöhte Zerstäubungsrate erzielt wird.

Nun wird hinzu der Prozess im Uebergangsmode UM betrieben.

Je nach gefahrenem Prozess sind die Uebergänge von metallischem in reaktiven Mode, was "Sprunghöhe" bzw. Uebergangssteilheit anbelangt, unterschiedlich. Insbesondere wurde ja auch erfindungsgemäss erkannt, dass der Uebergang, wie bei s schematisch dargestellt, insbesondere mit zunehmender Leistung des AC-Anteils flacher gestellt werden kann. Damit ist es durchaus möglich, in gewissen Fällen den Prozess lediglich durch Festhalten von Prozessbedingungen im Uebergangsmode zu betreiben.

Es sei an dieser Stelle nochmals festgehalten, dass die in den Fig. 1(a), (b) dargestellten Sprünge nur erläuternden Charakter haben und keine quantitative Darstellung dieser Uebergänge sein sollen.

Diese Stabilisierung im Uebergangsmode UM wird bevorzugterweise mittels einer für den Gleichstrombetrieb aus (4) bzw. (9) bekannten Prozessregelung des Arbeitspunktes des Prozesses, nun aber bei wechselstromüberlagertem Gleichstrombetrieb, d.h. im Bereich $UM_{AC+DC}$, wie beispielsweise bei X dargestellt, vorgenommen und dabei erkannt, dass hier, im Uebergangsmode $UM_{AC+DC}$, eine wesentliche Erhöhung des Reaktionsgrades $\gamma$ möglich ist, verglichen mit dem erreichbaren Reaktionsgrad $\gamma$ bei Gleichstrombetrieb im Uebergangsmode.

Aus (9) ist es bekannt, dass, beim Einsatz reiner Wechselstrom(AC)-Zerstäubung unterschiedlicher Leistungen, Prozesshystereseverläufe von Zerstäubungsrate und Massefluss, gemäss Darstellung (b) von Fig. 1, entstehen und dass in der Verlaufschar Punkte, welche auf einer gemeinsamen, durch den Ursprung des Koordinatensystems verlaufenden Gerade g liegen, gleiche Reaktionsgrade $\gamma$ der Beschichtung ergeben. Es sind mithin solche Geraden g die Orte im wesentlichen gleichen Reaktionsgrades $\gamma$.

Das erfindungsgemässe Faktum, dass bei stabilisiertem Prozess im Uebergangsmode, bei Prozessbetrieb mit wechselstromüberlagertem Gleichstrom, der Reaktionsgrad $\gamma$ wesentlich erhöht werden kann, verglichen mit DC-Betrieb im Uebergangsmode, ergibt sich nun mit einiger Wahrscheinlichkeit daraus, dass im wesentlichen unabhängig, ob die angelegten elektrischen Leistungen Gleichstrom- oder Gleich- und Wechselstrom- oder Wechselstrom-Leistungen sind, bei ansonst gleichen Betriebsbedingungen, wiederum Hystereseverlaufpunkte, welche auf einer durch den Ursprung gehenden Gerade liegen, im wesentlichen zu gleichen Reaktionsgraden $\gamma$ der Beschichtung führen.

So ist in der Darstellung gemäss (b) der Reaktionsgrad an den Verlaufkippstellen $K_{DC}$ und $K_{AC+DC}$ im wesentlichen gleich, auf der Geraden $g_1$, und wird maximal, gegen den reaktiven Mode hin, entsprechend der Geraden $g_2$. Durch Legen einer Geradenschar G, wie in Fig. 1(b) eingetragen, ergibt sich mithin eine Skalierung im Uebergangsmode UM bezüglich Reaktionsgrad $\gamma$.

Der Prozessarbeitspunkt könnte, aufgrund der vorgesehenen Prozessregelung bzw. -stabilisierung, nahe an den Uebergang in den reaktiven Mode RM gelegt werden, wobei aber, vereinfachend gesprochen, diesbezüglich ein Abstand D eingehalten werden müsste, um nicht, ungewollt, z.B. durch nie ganz zu vermeidende Regelabweichungen in den Reaktivmode zu gelangen, wo sich die Prozessverhältnisse drastisch ändern. Ein ungewolltes kurzzeitiges Verschieben des Arbeitspunktes in den Reaktivmode RM würde zum definitiven Kippen des Prozesses in den Reaktivmode führen.

Nun ist es aber bereits grundsätzlich ersichtlich, dass bei Betrieb des Prozesses erfindungsgemäss im Uebergangsmode $UM_{AC+DC}$ und mit wechselstromüberlagertem Gleichstrom, ein wesentlich höherer Reaktionsgrad $\gamma_{maxAC+DC}$ der Beschichtung erreicht werden kann als beim DC-Betrieb, $\gamma_{maxDC}$.

Daraus lässt sich erklären, warum erfindungsgemäss bei AC+DC-Betrieb höhere Reaktionsgrade $\gamma$ aufgrund der vorgesehenen Stabilisierung, vorzugsweise mittels Regelung, höchst stabil und damit homogen an der Beschichtung am Werkstück erzielt werden, verglichen mit im Uebergangsmode stabilisiertem DC-Betrieb.

Ein Arbeitspunkt x, vorzugsweise durch Regelung im Uebergangsmode stabilisiert, kann nun, wie mit dem Doppelpfeil T in Darstellung (b) dargestellt, im Uebergangsmode gemäss einem erwünschten Reaktionsgrad $\gamma$ eingestellt werden, der immer höher sein wird als im Falle des Gleichstrombetriebes und gleicher Zerstäubungsrate r. Der Reaktionsgrad kann, beherrscht bis hin zu nahezu höchstmöglichen Werten, eingestellt werden, entsprechend $\gamma_{maxAC+DC} > \gamma_{maxDC}$.

Wie erwähnt wurde, basieren die Erläuterungen bis dahin auf den bekannten und an sich vermuteten Prozessverläufen gemäss Fig. 1, insbesondere im Uebergangsmode UM.

Es wurde nun erfindungsgemäss weiter erkannt, dass, wenn bei erfindungsgemässem Betrieb der Prozessarbeitspunkt näher an den Metallmode gelegt wird, immer im Uebergangsmode betrachtet, erreicht wird, dass der Prozess mit einer optimal hohen Beschichtungsrate durchgeführt werden kann und dass mindestens nahezu stöchiometrische Schichten abgelegt werden. Dabei gilt auch hier, dass das Energieausbeuteverhältnis, wie erwähnt gegeben durch das Schichtvolumen pro Zerstäubungsenergie der erfindungsgemäss abgelegten Schicht zu Schichtvolumen pro Zerstäubungsenergie einer nicht reaktiv durch DC-Zerstäubung desselben Targetmaterials aufgebrachten Metall- bzw. leitenden Schicht $\geq 1$ wird.

Es wurde nun beobachtet, dass mindestens beim erfindungsgemässen Betrieb im Uebergangsmode die Zerstäubungsrate r in Funktion des Reaktionsgasmasseflusses $m^*$ sowie der Partialdruck p des Reaktivgases in Funktion des Reaktivgasmasseflusses $m^*$ qualitativ den in Fig. 1 gepunktet dargestellten Verläufen folgen. Daraus ist ersichtlich, dass in der Nähe des Metallmodes $MM_{AC+DC}$ eine hohe Zerstäubungsrate und damit Beschichtungsrate vorherrscht, bei hohem Reaktionsgasmassefluss, aber, in Funktion dieses Masseflusses, bei im wesentlichen konstantem Reaktivgaspartialdruck. Da das Uebermass zwischen der Geraden 1 und dem Partialdruckverlauf ein Mass für die Menge reagierten Gases darstellt, ist ersichtlich, dass mithin, bei hohem Reaktionsgrad $\gamma$ die Zerstäubungsrate r, bei Legen des Prozessarbeitspunktes $X_A$ näher an den Metallmode, optimal hoch gehalten werden kann. Dort herrscht, wie erwähnt, ein - bei gegebenem Fluss m*- hoher Reaktivgasverbrauch, was dafür Indiz ist, dass der Reaktionsgrad $\gamma$ hoch ist. Eine bevorzugte Arbeitspunktlage ist in Fig. 1 qualitativ bei $X_A$ eingetragen.

Durch die erfindungsgemäss vorgesehene Gleichstrom-Wechselstromzerstäubung und der Wahl des Prozessarbeitspunktes $X_A$ im Uebergangsmode UM, vorteilhafterweise, zum Erhalt eines möglichst hohen Beschichtungsgrades $\gamma$ bei hoher Beschichtungsrate, in der Nähe des Metallmodes, wird gegenüber dem bei Gleichstrombetrieb im Uebergangsmode stabilisierten Prozess eine wesentlich erhöhte Abscheidungsrate gleichzeitig mit erhöhtem Reaktionsgrad $\gamma$ der Schicht erreicht. Mit Hilfe der schnellen Regelung wird nun verhindert, dass der Arbeitspunkt in den Metall- oder gegebenenfalls in den Reaktivmode abwandert.

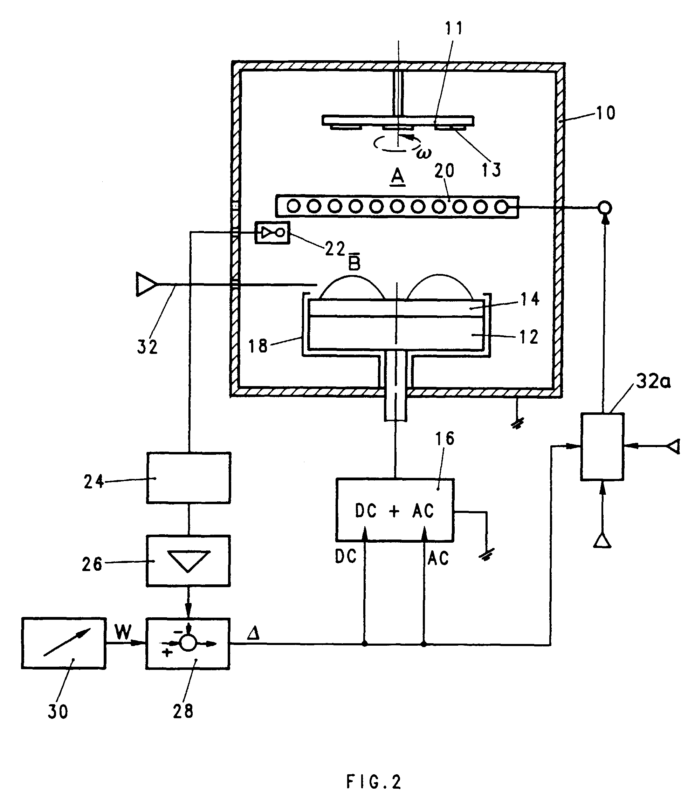

In Fig. 2 ist schematisch eine erfindungsgemässe Anlage zur Ausführung des erfindungsgemässen Verfahrens dargestellt. In einer Vakuumkammer 10, mit beispielsweise auf Masse liegendem Gehäuse, ist ein Werkstückträger 11 vorgesehen mit Werkstücken 13. Dem Werkstückträger 11 gegenüberliegend ist eine Targethalterung 12 vorgesehen mit einem zu zerstäubenden Target 14 aus ohmisch leitendem Material. Das Target 14 wird über die Halterung 12 von einer elektrischen Quelle 16 betrieben, welche ein Gleichstromsignal DC mit überlagertem Wechselstromsignal AC abgibt. In den zwischen Werkzeugträger 11 und Target 14 gebildeten Reaktionsraum A, mit auch als Anode wirkender Dunkelraumabschirmung 18, mündet ein Zuleitungssystem 20, wie schematisch dargestellt, mit einer Mehrzahl von Einlässen für Arbeitsgas, darin enthaltend das reaktive Gas bzw. Gasgemisch, wie beispielsweise Sauerstoff. Es hat sich gezeigt, dass Frequenzen von 50Hz bis 250kHz, vorzugsweise von 10kHz bis 200kHz für den AC-Anteil der Quelle 16, ausserordentlich geeignet sind.

Je nach Prozess wird aber der Wechselstromanteil AC als Impulsanteil, als reiner Sinus oder als Ueberlagerung von Sinussignalen mit zwei und mehr Frequenzen erzeugt. Dies bei Frequenzen von 100Hz oder gar 10Hz bis in den Mikrowellenbereich, aber vorzugsweise bis 15MHz. Das Target, insbesondere ein erfindungsgemäss Phosphor-dotiertes Si-Target, das einkristallin gezogen oder aber gegossen ist, weist vorzugsweise eine Leitfähigkeit von $0{,}01\Omega cm$ bis $100\Omega cm$, vorzugsweise von 0,01 bis $1\Omega cm$ auf. Die AC-Leistung ist wesentlich tiefer als die DC-Leistung, was den Einsatz eines kostengünstigen, auf Halbleiter-Elementen basierenden AC-Generators in 16 erlaubt.

Die Einlasseinrichtung 20 wird von nicht dargestellten Behältnissen mit dem vorgegebenen Gas bzw. Gasgemisch gespeist. Im weiteren kann durch die schematisch dargestellte Einlassanordnung 32 das Arbeitsgas, insbesondere Argon, separat eingelassen werden, und zwar gegen den Reaktionsraum A z.B. abgeschottet, näher ans Target, oder direkt in den Reaktionsraum etc. je nach erwünschtem Prozess, wie z.B. aus (4) bekannt. Mit der Quelle 16 wird im Reaktionsraum eine Glimmentladung betrieben und dabei das Target 14 abgestäubt. Die abgestäubten Teilchen reagieren im Prozessraum A, in der Glimmentladung, mit dem reaktiven Gas, das schlechter leitende, z.B. dielektrische Reaktionsprodukt setzt sich als Beschichtung insbesondere auf die Werkstücke 13 am Werkstückträger 11 nieder.

Wie weiter schematisch dargestellt, ist ein Regelkreis für die Stabilisierung des Zerstäubungs- und Beschichtungsprozesses vorgesehen. Er umfasst einen IST-Wert-Nehmer 22, bevorzugterweise einen oder mehrere Sensoren aus folgender Gattung umfassend:

- optische,

- Absorptions- und/oder Emissions- und/oder Fluoreszenzspektroskopie-Sensoren,

- Lichtemissions-Erfassungs-Sensoren,

- Plasmamonitor-Sensoren, wie von der Anmelderin vertrieben,

- Entladungs-Impedanz-Sensoren,

- Partialdruck-Mess-Sensoren.

Das Ausgangssignal des IST-Wert-Aufnehmers wird einer Aufbereitungs- und Auswerteeinheit 24, 26 zugeführt. Nach der Signalaufbereitung wird das IST-Wert-Signal S einer Differenzeinheit 28 zugeführt. Hier wird die Regeldifferenz $\Delta$ gebildet mit Bezug auf einen eingestellten SOLL-Wert W, an einer Einheit 30 verstellbar.

Die Regeldifferenz $\Delta$ wird, über (nicht dargestellte) Regler zur Optimierung des Regelverhaltens, einer Prozessgrösse als Stellgrösse zugeführt, die schnell reagiert. Als Stellgrössen mit entsprechenden Stellern werden vorzugsweise ein oder mehrere der folgenden eingesetzt:

- Leistung DC (Strom u/o Spannung),

- Leistung AC (Strom- u/o Spannungsamplitude),

- Frequenz AC,

- Frequenzspektrum AC,

- Verhältnis Leistung AC/Leistung DC,

- Reaktionsgasmassefluss,

- Gasmischung,

- Arbeitsgasmassefluss.

In Fig. 2 wird auf den DC- und AC-Teil und, über Ventil 32a, auf den Reaktionsgasmassefluss eingegriffen. Vorzugsweise mit Hilfe des Regelkreises wird, wie erläutert worden ist, der Zerstäubungs- und Beschichtungsprozess im Uebergangsmode $UM_{AC+DC}$ stabilisiert. Zur weiteren Erhöhung der Plasmadichte im Targetbereich, und damit der Abstäubungsrate, wird bevorzugterweise das Target 14 in einer Magnetronquelle betrieben, wie dies schematisch durch die bekanntlich darin vorgesehenen Magnetfelder B dargestellt ist.

Gegenüber herkömmlichen Beschichtungsanlagen mit Targetzerstäubung wird hier das Target gleich- und wechselstrombetrieben, und es ist vorzugsweise ein schneller Regelkreis vorgesehen, um regelnd den Prozessarbeitspunkt zu stabilisieren.

Ist der erfindungsgemäss erreichte Reaktionsgrad γ gegebenenfalls nicht ausreichend, so wird die Beschichtung der Werkstücke 13 nachreagiert. Dies kann (nicht dargestellt) dadurch geschehen, dass die Schicht in der Kammer 10 selbst in Reaktivgas nachreagiert wird, mit oder ohne Glimmentladung, vorzugsweise unter Einwirkung zusätzlich (nicht dargestellt) eingeführter Energie, wie durch

- Licht (Laser, UV),

- Ionen-Strahlen,

- Elektronen-Strahlen,

- Heizen,

- Plasma,

- HF oder Mikrowellen,

mittels entsprechender Aggregate. Dieses Nachreagieren erfolgt in einer Reaktionsgasatmosphäre desselben Reaktionsgases.

Der Werkstückträger wird stationär gehalten oder langsam oder intermittierend bewegt, vorzugsweise gedreht.

Dabei ist es durchaus möglich und teilweise bevorzugt, die in Fig. 2 dargestellte Anlage mit einer "Nachreaktions"-Stufe in Linie zu koppeln und die Werkstücke 13 nach Zerstäubungsbeschichtung in eine an die Kammer 10 angeschaltete Nachreaktionsstufe überzuführen. Durch bekannte Druckentkopplung, sei dies mittels Schleusen oder lediglich mittels Druckstufen, kann eine weitgehende Entkopplung des Prozessdruckes im Prozessraum A vom Reaktivgasdruck in einer solchen Nachbehandlungsstufe erreicht werden.

Damit das erfindungsgemässe Verfahren bzw. die erfindungsgemässe Anlage im instabilen Uebergangsmode in jedem beliebigen Arbeitspunkt und insbesondere nahe an den Uebergang in den Metallmode stabil betrieben werden kann, muss sichergestellt sein, dass der Arbeitspunkt des Prozesses nicht durch Störgrösseneinfluss, wie Schwankungen der Glimmentladungsspeisung, Schwankungen des Reaktivgasdruckes, Inhomogenitäten im Targetmaterial, so weit verschoben wird, wenn auch nur kurzzeitig, dass er in den Metallmode umkippt.

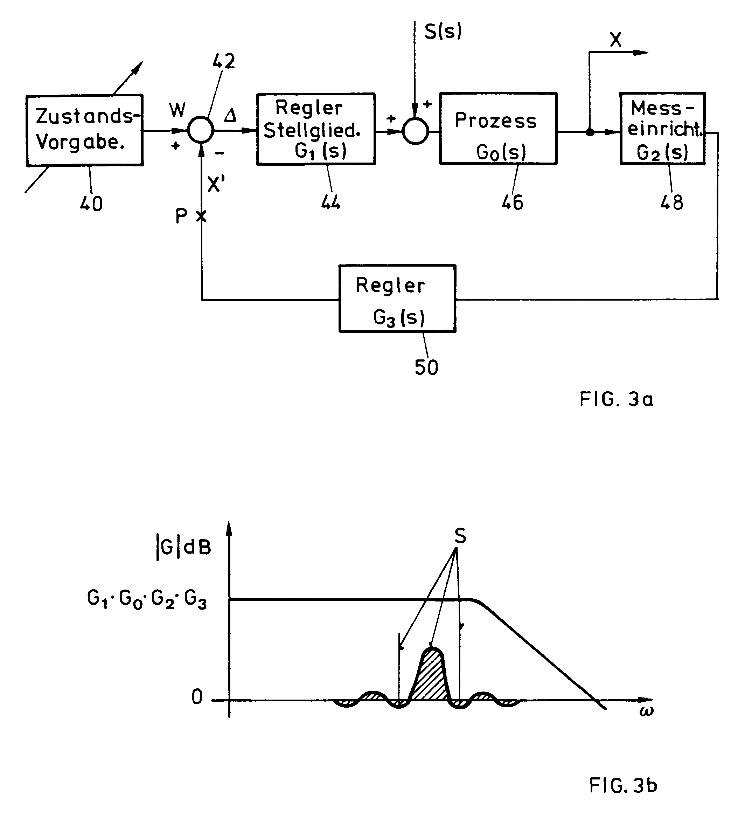

In Fig. 3a ist das Blockdiagramm eines erfindungsgemäss eingesetzten Regelkreises dargestellt. Die Darstellung entspricht derjenigen einer Regelung auf vorgegebene Arbeitspunktwerte, wobei, aufgrund der Komplexität und der Vielfalt der einflussnehmenden Stellparameter, sich durchaus auch eine Zustandsregelung bekannter Art für das vorgeschlagene Regelverfahren eignet.

Grundsätzlich wird an eine Zustandsvorgabeeinheit 40 bzw. SOLL-Wert-Vorgabeeinheit der SOLL-Wert W vorgegeben, an einer Vergleichseinheit 42 mit dem rückgeführten gemessenen IST-Wert X' verglichen. Die Regeldifferenz Δ wirkt, gegebenenfalls über einen Regler, auf eine Stellgliedeinrichtung 44, welch letztere mindestens eine Grösse stellt, die den Prozessarbeitspunkt beeinflusst. Bei 46 ist der Prozess als Regelstrecke dargestellt, der Arbeitspunkt X ist die geregelte Grösse. Letzterer wird mit einer Messeinrichtung 48 erfasst, das Ausgangssignal der Messeinrichtung 48 über einem Regler 50 als gemessene Regelgrösse X' auf die Vergleichseinheit 42 rückgeführt.

Störgrössen S, welche den Arbeitspunkt X bzw. $X_A$ in untolerablem Masse verschieben könnten, sind zwischen Stellglied 44 und Prozess 46 eingetragen. Es bezeichnen G(s) die jeweiligen Uebertragungsfunktionen, wobei s, wie dem Fachmann bekannt, die Variable der Laplace-Transformation bezeichnet.

Wie in Fig. 3b dargestellt, muss die erfindungsgemäss eingesetzte Regelung am offenen Regelkreis, d.h. zwischen Vorgabeeinheit 40, d.h. W (Fig. 3a), und dem in Fig. 3a eingetragenen Punkt P, dort aufgeschnitten, eine Verstärkung aufweisen, welche bis zu Frequenzen wesentlich grösser als 1 (0dB) ist, bei welchen die Störgrössen S, wie schematisch in Fig. 3b eingetragen, auftreten. Ist diese Bedingung erfüllt, so werden die Störgrössen S rasch ausgeregelt und vermögen nicht den Arbeitspunkt X massgeblich zu verschieben.

Mit einer im wesentlichen nach Fig. 2 dargestellten Anlage und mit den nachfolgend eingestellten Prozessparametern wurden die ebenfalls nachfolgend wiedergegebenen Resultate ohne separates Nachreagieren erreicht:

Beispiel:

| | |
|---|---|
| Leistung DC: | 2 kW |
| Leistung AC: | 0,5 kW |
| Frequenz AC: | 200 kHz |
| Targetspannung: | -345 V |
| Targetstrom: | 7,2 A |
| Ar-Gasdruck: | $8 \cdot 10^{-3}$ mbar |
| Ar-Gasfluss: | 16,5 sccm |
| $O_2$-Partialdruck: | $10^{-4}$ mbar |
| Target-Gegenstand-Abstand: | 60 mm |
| Target: | Leitfähigkeit $< 0,5 \ \Omega cm$, Phosphor-dotiertes Si, Typ AK 510 Si der Anmelderin |
| Magnetronsystem: | MA 510 der Anmelderin |
| Zerstäubungszeit: | 1080 sec |
| Schichtdicke: | 583 nm |
| Korb für Substrate (Gegenstände): | Ø 400 mm |
| Rate auf Korb: | 0,54 nm/sec |
| Drehfrequenz Korb: | 0,3 Hz |
| dynamische Rate: | DDR = 60,5 nm $\cdot$ mm$^2$/Ws |
| Energieausbeute: | 0,6 (nm/s)/(W/cm$^2$) |
| $SiO_2$ Brechwert bei $\lambda = 633$ nm: | n = 1,465 |
| $SiO_2$ Absorptionskoeffizient bei $\lambda = 633$ nm: | $k < 10^{-4}$ |
| $SiO_2$ Absorptionskoeffizient bei $\lambda = 382$ nm: | $1,5 \cdot 10^{-4}$ |

Fth = 2,5; $\qquad\qquad\qquad$ $F_{exp} = 1,2$

Es lässt sich folgern:

Der erhöhte Reaktionsgrad wirkt sich stark vorteilhaft für die sich bildende Schicht am Werkstück aus und wäre - bei DC - ebenso stark nachteilhaft am Target, wo sich vermehrt eine Reaktivgasschicht bilden würde, die das Target vergiften würde. Mit der AC+DC-Entladung gelingt es, im Gegensatz zu einer reinen DC-Entladung, sehr effektiv das Target zu zerstäuben und am Werkstück die dielektrische Schicht abzulegen. Es ergibt sich ein starker Reaktionsgrad-Gradient zwischen Target und Werkstück. Ein niedriger Reaktionsgrad am Target, d.h. eine geringere effektive Reaktionsgasschichtbildung durch fortwährendes AC-zerstäuben, führt zu hohen Raten, ein hoher Reaktionsgrad am Werkstück zu homogen stöchiometrischem Schichtwachstum.

Der Gradient erlaubt es, die Energieausbeute, definiert als: "gebildetes Schichtvolumen pro aufgewandter Energie", beim Aufstäuben einer reaktiv gebildeten Schicht theoretisch um den Faktor Fth gegenüber der Energieausbeute beim DC-Aufstäuben einer Metallschicht (nicht reaktiv!) zu verbessern. Es gilt folgender Zusammenhang für die theoretisch maximal mögliche (Fth) und experimentell gemessene (Fexp) Verbesserung:

Fth = $\qquad$ (Mr/Mm)/(Dr/Dm)

Fexp = $\qquad$ (Vr/Er)/(Vm/Em)

(Mr = Molekulargewicht der reaktiv gebildeten Schicht; Mm = Atomgewicht des Metalls; Dr bzw. Dm sind Dichte von reaktiv gebildeter Schicht bzw. von Metallschicht; Vr bzw. Vm Volumen der reaktiv gebildeten Schicht bzw. der Metallschicht; Er bzw. Em Energieaufwand beim Zerstäuben im Reaktivprozess bzw. im Metallzerstäubungsprozess).

Die Energieausbeute war beim nicht reaktiven Metallzerstäuben bis anhin grösser, meist wesentlich grösser als beim Reaktivgaszerstäuben. Erfindungsgemäss wird die Energieausbeute beim Reaktivgaszerstäuben nun grösser als beim Metallzerstäuben.

Das erfindungsgemässe Verfahren sowie die Anlage hierfür eignen sich auch zur Herstellung von $Al_2O_3$-oder $Si_3N_4$-Schichten, ab Al- oder Si-Targets, insbesondere aber für die Herstellung von $SiO_2$-Schichten ab Si-Targets, insbesondere erfindungsgemäss dotiertem Si-Target. Mit einiger Wahrscheinlichkeit werden sich auch andere nicht oder schlecht leitende Schichten erfindungsgemäss und mit den angegebenen Vorteilen herstellen lassen.

Bei der Bestimmung des Energieausbeuteverhältnisses wird, als Vergleichsbasis, dasselbe Targetmaterial aber nicht reaktiv zerstäubt.

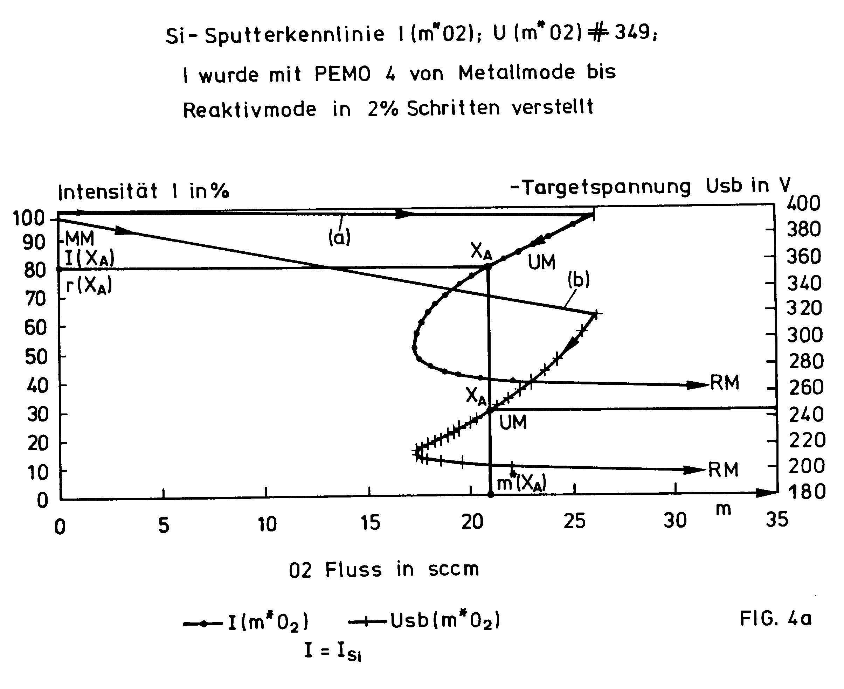

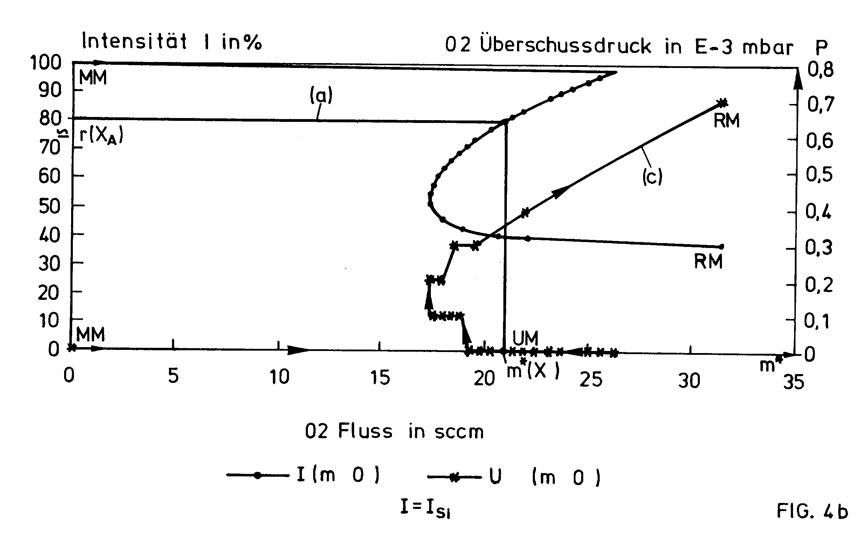

In den Fig. 4a und 4b sind die Zerstäubungskennlinien (a), (b), (c) bei erfindungsgemässem Zerstäuben von Silicium dargestellt, bei der erfindungsgemässen Herstellung der besonders bevorzugten $SiO_2$-Schicht.

In Fig. 4a ist in einem ersten Koordinatensystem mit der linken vertikalen Koordinatenachse die Intensität I der Siliciumlinie in Prozent abgetragen, über dem Massefluss m* des Reaktivgases $O_2$. Die Intensität I der Siliciumlinie (254nm) ist proportional zur Zerstäubungsrate r des Siliciumtargets. Der Prozess wurde an einer wie anhand von Fig. 2 beschriebenen Anlage durchgeführt. Der charakteristische Verlauf der Zerstäubungsrate r über dem Reaktivgasmassefluss m* ist mit (a) bezeichnet. Die darauf aufgetragenen Punkte sind Messpunkte. Durchlaufen wird der Verlauf (a) in mit den Pfeilen angegebener Richtung. Im weiteren sind Metallmode MM, Uebergangsmode UM und Reaktivmode RM eingezeichnet.

In Fig. 4b ist im zweiten Koordinatensystem, mit der rechten Vertikalachse, wiederum über dem Massefluss m* des Reaktivgases $O_2$ der Partialdruck von $O_2$ eingetragen, dessen Nullpunkt dem Druck des Argongases entspricht. Auch hier wird die Charakteristik (c) in der mit den Pfeilen angegebenen Richtung durchlaufen, die Messpunkte sind mit * bezeichnet, und es sind wiederum Metallmode MM, Uebergangsmode UM sowie Reaktivmode RM eingetragen.

In Fig. 4a ist weiter, im zweiten Koordinatensystem, mit der rechten Vertikalachse, der Verlauf der am Target gemessenen Spannung Usb über dem Reaktivgasmassefluss m* dargestellt. Auch hier sind die Messpunkte sowie die Richtung, mit welcher die Charakteristik durchlaufen wird, von Messpunkt zu Messpunkt fortschreitend, eingetragen.

Daraus ist, beim hier dargestellten Prozess, der qualitativ bereits in Fig. 1 gepunktet dargestellte Verlauf erkenntlich. Insbesondere ist auf den charakteristischen Verlauf im Uebergangsmode UM hinzuweisen, worin die Zerstäubungsrate r, proportional zur Siliciumlinienintensität I, in Funktion des Reaktivgasmasseflusses m* zunimmt und gleichzeitig, über einen weiten Bereich in diesem Uebergangsmode UM, der Partialdruck p des Reaktivgases $O_2$ in Funktion des Reaktivgasmasseflusses m* konstant bleibt.

Es ist in den Fig. 4a und 4b ein beispielsweise und bevorzugterweise für einen erfindungsgemässen Beschichtungsprozess gewählter Arbeitspunkt eingetragen und mit $X_A$ bezeichnet.

**Patentansprüche**

1. Verfahren zur Beschichtung mindestens eines Gegenstandes mit mindestens einer Schicht, wobei ein ohmisch leitendes Target in einer mittels Gleichstrom und diesem überlagertem Wechselstrom betriebenen Glimmentladung zerstäubt wird und die abgestäubten Teilchen im Raum zwischen Target und Werkstück mit einem Gas zur Reaktion gebracht werden und am Werkstück abgelegt werden und dabei der Beschichtungsprozess im instabilen Uebergangsmode zwischen metallischem und reaktivem Mode betrieben wird und die Schicht elektrisch schlechter leitet als das Material des Targets, dadurch gekennzeichnet, dass der Wechselstrom einen leistungsmässig dominanten Spektralanteil zwischen 10Hz und 250kHz (je inklusiv) aufweist.

2. Verfahren nach Anspruch 1, dadurch gekennzeichnet, dass der dominante Spektralanteil zwischen 50Hz und 250kHz vorzugsweise zwischen 10kHz und 200kHz (je inklusiv) liegt.

3. Verfahren nach einem Anspruch 1 oder 2, dadurch gekennzeichnet, dass das Energieausbeuteverhältnis, gegeben durch Schichtvolumen der Schicht pro eingesetzte Zerstaubungsenergie zu Schichtvolumen einer nicht reaktiv abgelegten Schicht des Targetmaterials zu dazu eingesetzter Zerstäubungsenergie, $\geq 1$, vorzugsweise $> 1$ ist.

4. Verfahren nach einem der Ansprüche 1 bis 3, dadurch gekennzeichnet, dass der Prozess im instabilen Uebergangsmode durch Regelung stabilisiert wird.

5. Verfahren nach einem der Ansprüche 1 bis 4, dadurch gekennzeichnet, dass der Beschichtungsprozess im instabilen Uebergangsmode in der Nähe zum Uebergang in den metallischen Mode stabilisiert wird.

6. Verfahren nach einem der Ansprüche 1 bis 5, dadurch gekennzeichnet, dass als Stellgrösse in einem Prozessarbeitspunkt-Regelkreis das Gleichstromsignal und/oder Frequenz und/oder Amplitude des Wechselstromsignals eingesetzt werden und/oder das Verhältnis Gleichstromleistung zu Wechselstromleistung und/oder der Reaktivgasmassefluss und vorzugsweise dabei die IST-Wert-Erfassung erfolgt durch ein optisches Verfahren, insbesondere durch Absorptions- und/oder Emissions-und/oder Fluoreszenzspektroskopie der Plasma-Lichtemission und/oder Erfassung der Entladungsimpedanz und/oder des Gas-Partialdruckes und/oder mittels eines Plasma-Monitors, z. B. wie von der Firma Balzers AG, Balzers, FL, vertrieben.

7. Verfahren nach einem der Ansprüche 1 bis 6, dadurch gekennzeichnet, dass der Betriebspunkt des Prozesses messtechnisch als IST-Zustand oder Wert erfasst wird, mit einem SOLL-Zustand oder -Wert verglichen wird, über mindestens ein Stellglied in Abhängigkeit vom Vergleichsresultat auf den Prozess eingegriffen wird als Arbeitspunktregelung, und dass die Verstärkung des offenen Regelkreises wesentlich grösser als 1 ist, bis mindestens hin zu Störgrössenfrequenzen von Störgrössen, die am Prozess eingreifen und dessen Arbeitspunkt wesentlich beeinflussen.

8. Verfahren nach einem der Ansprüche 2 bis 7, dadurch gekennzeichnet, dass die Beschichtung zusätzlich nachreagiert wird.

9. Verfahren nach Anspruch 8, dadurch gekennzeichnet, dass die Nachreaktion in einem Gas und durch zusätzlich eingebrachte Energie, wie durch Licht-, Teilchen-, dabei Ionen-oder Elektronen-Enegie, thermische Energie, Plasma-Energie, Mikrowellen- bzw. HF-Energie, mindestens unterstützt wird und in und/oder ausserhalb der bzw. einer Glimmentladung erfolgt.

10. Verfahren nach einem der Ansprüche 1 bis 9, dadurch gekennzeichnet, dass der Gegenstand für die Beschichtung stationär gehalten oder mindestens zeitweise bewegt wird.

11. Verfahren nach einem der Ansprüche 1 bis 10, dadurch gekennzeichnet, dass der Gegenstand auf einer Rotationsbahn bewegt wird mit einer Drehfrequenz wesentlich unterhalb des dominanten Spektralanteils des Wechselstromes, vorzugsweise mit einer Drehfrequenz $\leq$ 1Hz.

12. Verfahren nach einem der Ansprüche 1 bis 11, dadurch gekennzeichnet, dass mit dem Wechselstromanteil die Prozesskennlinie zwischen metallischem und reaktivem Mode gesteuert, insbesondere abgeflacht wird.

13. Verfahren nach einem der Ansprüche 1 bis 12, dadurch gekennzeichnet, dass der Wechselstromanteil mindestens zwei Frequenz-Spektrallinien aufweist oder ein kontinuierliches Spektrum.

14. Verfahren nach einem der Ansprüche 1 bis 13, dadurch gekennzeichnet, dass der Wechselstromanteil durch einen Halbleiter-aufgebauten Generator erzeugt wird.

15. Verfahren nach einem der Ansprüche 1 bis 14, dadurch gekennzeichnet, dass das Target ein dotiertes Si-Target ist.

16. Verfahren nach einem der Ansprüche 1 bis 15, dadurch gekennzeichnet, dass das Target eine Leitfähigkeit von 0,01 bis 100 $\Omega$cm (beides inklusiv) aufweist, vorzugsweise zwischen 0,01 und 1 $\Omega$cm (beides inklusiv).

17. Verfahren nach einem der Ansprüche 1 bis 16, dadurch gekennzeichnet, dass das Target ein Phosphor-dotiertes Target, vorzugsweise Si-Target, ist, einkristallin gezogen oder gegossen.

18. Verfahren nach einem der Ansprüche 1 bis 17, dadurch gekennzeichnet, dass das Target ein Si- oder Al-Target ist und die Schicht eine $Al_2O_3$- oder $SiO_2$- oder $Si_3N_4$-Schicht.

19. Verfahren nach einem der Ansprüche 1 bis 18, dadurch gekennzeichnet, dass das Target ein Si-Target ist, vorzugsweise Phosphor-dotiert, und die Schicht $SiO_2$, wobei das Energieausbeuteverhältnis, gegeben durch Schichtvolumen pro eingesetzte Zerstäubungsenergie zu Schichtvolumen einer abgelegten Si-Schicht zu dazu eingesetzter Metallzerstäubungsenergie, $\geq 1,2$ ist, bereits ohne Nachreaktion nach Anspruch 8.

20. Verfahren nach einem der Ansprüche 1 bis 19, dadurch gekennzeichnet, dass der Uebergang von metallischem zu reaktivem Mode, was seine Lage und/oder seinen Verlauf anbelangt, durch das angelegte Wechselstromsignal, dessen Leistung und/-oder Frequenz eingestellt werden kann.

21. Beschichtungsanlage zur Ausführung des Verfahrens nach einem der Ansprüche 1 bis 20, umfassend eine kathodisch geschaltete, ohmisch leitende Targetanordnung (12, 14), eine Anodenanordnung (10, 18) sowie eine elektrische Quelle (16) über Anoden- und Kathodenanordnung, zur Erzeugung einer Glimmentladung zwischen Kathodenanordnung und Anodenanordnung, einen Gegenstandsträger (11) sowie mindestens eine Einlassanordnung (20, 32) für ein Gas in den Raum (A) zwischen Werkstück (13) und Targetanordnung (14), weiter mit Mitteln (22, 28, 32a), die den Beschichtungsprozess im an sich instabilen Uebergangsmode halten, wobei die Quelle (16) Gleichstrom (DC) mit überlagertem Wechselstrom (AC) abgibt, dadurch gekennzeichnet, dass die Quelle (16) einen Wechselstrom (AC) abgibt mit einem leistungsmässig dominanten Spektralanteil zwischen 10Hz und 250kHz (je inklusiv).

22. Anlage nach Anspruch 21, dadurch gekennzeichnet, dass der dominante Spektralanteil zwischen 50Hz und 250kHz, vorzugsweise zwischen 10kHz und 200kHz (je inklusiv) liegt.

23. Anlage nach Anspruch 21 oder 22, dadurch gekennzeichnet, dass die Mittel einen schnellen Regelkreis für den Prozess umfassen.

24. Anlage nach einem der Ansprüche 21 bis 23, dadurch gekennzeichnet, dass mindestens ein Messwertaufnehmer (22) vorgesehen ist, der mindestens einen für den Prozessarbeitspunkt relevanten Messwert aufnimmt, dass dessen Ausgang auf eine Vergleichseinheit (28) geführt ist, welcher, von einer Vorgabeeinheit (30), ein dem Messwert entsprechender SOLL-Wert (W) zugeführt ist, dass der Ausgang der Vergleichseinheit ($\Delta$) auf eine den Prozessarbeitspunkt beeinflussende Stelleranordnung (32a) in regelndem Sinne wirkt und dass die Verstärkung des offenen Regelkreises bis zu Frequenzen wesentlich grösser als 1 ist, mit denen Arbeitspunkt-beeinflussende Störgrössen (S) in den Prozess eingreifen.

25. Anlage nach einem der Ansprüche 21 bis 24, dadurch gekennzeichnete, dass Stellglieder (16, 32a) für die Einstellung des Betriebsarbeitspunktes, insbesondere für das Reaktivgas, so eingestellt oder einstellbar sind, dass die Anlage im instabilen Uebergangsmode (UM) arbeitet.

26. Anlage nach Anspruch 25, dadurch gekennzeichnet, dass die Stellglieder so gestellt sind oder so stellbar sind, dass die Anlage in der Nähe des metallischen Modes (MM) arbeitet.

27. Anlage nach einem der Ansprüche 25 oder 26, dadurch gekennzeichnet, dass die Stellglieder so gestellt oder stellbar sind, dass die Anlage eine Beschichtung erzeugt, deren Energieausbeuteverhältnis, gegeben durch Schichtvolumen der Schicht, pro eingesetzte Zerstäubungsenergie zu Volumen einer Schicht aus Targetmaterial zu dazu eingesetzter Zerstäubungsenergie $\geq 1$ ist, vorzugsweise > 1, dass dabei vorzugsweise das Target ein im wesentlichen aus Si bestehendes Target ist, dass eine Gaszuführung (20) mit einem $O_2$-Vorrat verbunden ist und die erzeugte $SiO_2$-Schicht ein Energieausbeuteverhältnis von $\geq$ 1,2 aufweist.

28. Anlage nach einem der Ansprüche 21 bis 27, dadurch gekennzeichnet, dass als mindestens ein IST-Wert-Nehmer des Regelkreises vorgesehen sind:

   - eine optische Nehmer-Einrichtung, insbesondere eine Absorptions- und/oder Emissions- und/oder Fluoreszenzspektroskopie-Einrichtung und/oder eine Plasma- oder Licht-Erfassungseinrichtung und/oder eine Entladungs-Impedanz-Messeinrichtung und/oder eine Partialdruck-Messeinrichtung und/oder ein Plasma-Monitor, wie durch die Anmelderin vertrieben.

29. Anlage nach einem der Ansprüche 21 bis 28, dadurch gekennzeichnet, dass die Targetanordnung (12, 14) ein phosphor-dotiertes Target, vorzugsweise Si-Target, umfasst, einkristallin oder gegossen.

30. Anlage nach einem der Ansprüche 21 bis 29, dadurch gekennzeichnet, dasss am Regelkreis mindestens ein Steller (16, 32a) vorgesehen ist für:

   - das Gleichstromsignal und/oder

   - Leistung und/oder Frequenz des Wechselstromsignals und/oder

   - Leistungsverhältnis von Gleich- und Wechselstromsignal und/oder

   - Reaktivgasmassefluss.

31. Anlage nach einem der Ansprüche 21 bis 30, dadurch gekennzeichnet, dass der Wechselstromanteil mittels eines Halbleiter-Generators erzeugt wird.

32. Anlage nach einem der Ansprüche 21 bis 31, dadurch gekennzeichnet, dass der Träger stationär ist oder zeitweise getrieben wird.

33. Anlage nach einem der Ansprüche 21 bis 32, dadurch gekennzeichnet, dass auf den Träger (11) ein Drehantrieb wirkt mit einer Drehfrequenz ($\omega$) wesentlich tiefer als diejenige eines leistungsmässig dominanten Spektralanteils des Wechselstromsignals (AC), vorzugsweise mit einer Drehfrequenz $\leq$ 1Hz.

34. Anlage nach einem der Ansprüche 21 bis 33, dadurch gekennzeichnet, dass eine Einrichtung, vorzugsweise von der Kathoden- und Anodenanordnung abgesetzt, vorgesehen ist, um vorzugsweise mittels weiterer zugeführter Energie, die Beschichtung in einer Gasatmosphäre nachzureagieren.

35. Anlage nach Anspruch 34, dadurch gekennzeichnet, dass an der Einrichtung Mittel, wie eine Ionenquelle und/oder eine UV-Quelle und/oder eine Lasereinrichtung, eine Plasmaquelle, eine Elektronenquelle, eine Lichtquelle, eine Heizeinrichtung, wie ein HF oder Mikrowellensender, vorgesehen sind.

36. Anlage nach einem der Ansprüche 21 bis 34, dadurch gekennzeichnet, dass das Targetmaterial (14) eine Leitfähigkeit von 0,01 bis 100$\Omega$cm (beides inklusiv) aufweist, vorzugsweise zwischen 0,01 bis 1$\Omega$cm (beides inklusiv).

## Claims

1. Process for coating at least one object with at least one layer, where an ohmically conductive target is sputtered in a glow discharge operated by direct current and alternating current overlaid over this, and the sputtered particles are brought to reaction with a gas in a chamber between the target and workpiece and deposited on the workpiece and thus the coating process operated in unstable transition mode between metallic and reactive mode and the layer conducts more poorly electrically than the material of the target, characterised in that the alternating current has a power-related dominant spectrum part of between 10 Hz and 250 kHz (inclusive).

2. Process according to claim 1, characterised in that the dominant spectrum part lies between 50 Hz and 250 kHz preferably between 10 kHz and 200 kHz (inclusive).

3. Process according to claim 1 or claim 2, characterised in that the energy recovery ratio, given by the layer volume of the layer per sputtering energy consumed to the layer volume of a non-reactively deposited layer of the target material per sputtering energy used for this, is $\geq 1$, preferably $> 1$.

4. Process according to any of claims 1 to 3, characterised in that the process in the unstable transition mode is stabilised by control.

5. Process according to any of claims 1 to 4, characterised in that the coating process in the unstable transition mode is stabilised in the vicinity of the transition to the metallic mode.

6. Process according to any of claims 1 to 5, characterised in that the direct current signal and/or frequency and/or amplitude of the alternating current signal are used as the correcting variable in a process working point control circuit and/or the ratio of direct current power to alternating current power and/or reactive gas mass flow and preferably the actual value assessment is carried out by an optical process, in particular by absorption and/or emission and/or fluorescence spectroscopy of the plasma light emission and/or detection of the discharge impedance and/or gas partial pressure and/or by means of a plasma monitor, eg. such as that sold by the company Balzers AG, Balzers FL.

7. Process according to any of claims 1 to 6, characterised in that the operating point of the process is detected by measurement as the actual state or value, compared with a nominal state or value, applied to the process as a working point control via at least one actuating element as a function of the comparison result, and that the amplification of the open control circuit is essentially greater than 1 up to at least disturbance frequencies of disturbance variables which act on the process and essentially influence its working point.

8. Process according to any of claims 2 to 7, characterised in that the coating is also reacted further.

9. Process according to claim 8, characterised in that the further reaction in a gas is at least supported by additionally supplied energy such as light, particle such as ion or electron energy, thermic energy, plasma energy, microwave or HF energy, and takes place in/and or outside the or a glow discharge.

10. Process according to any of claims 1 to 9, characterised in that the object for coating is held stationary or moved at least occasionally.

11. Process according to any of claims 1 to 10, characterised in that the object is moved on a rotation path with a rotation frequency essentially below the dominant spectrum part of the alternating current, preferably with a rotation frequency of $\leq 1$ Hz.

12. Process according to any of claims 1 to 11, characterised in that the alternating part controls, in particular flattens, the process characteristic curve between the metallic and reactive mode.

13. Process according to any of claims 1 to 12, characterised in that the alternating current part has at least two frequency spectrum lines or one continuous spectrum.

14. Process according to any of claims 1 to 13, characterised in that the alternating current part is generated by a semiconductor-based generator.

15. Process according to any of claims 1 to 14, characterised in that the target is a doped Si target.

16. Process according to any of claims 1 to 15, characterised in that the target has a conductivity of 0.01 to 100 $\Omega$cm (both inclusive), preferably between 0.01 and 1 $\Omega$cm (both inclusive).

17. Process according to any of claims 1 to 16, characterised in that the target is a phosphorus-doped target, preferably Si target, drawn or cast as a single crystal.

18. Process according to any of claims 1 to 17, characterised in that the target is an Si or Al target, and the layer an $Al_2O_3$ or $SiO_2$ or $Si_3N_4$ layer.

19. Process according to any of claims 1 to 18, characterised in that the target is an Si target, preferably phosphorus-doped, and the layer $SiO_2$, where the energy recovery ratio, given by the layer volume per sputtering energy used to the layer volume of a deposited Si layer per metal sputtering energy used for this, is $\geq 1.2$ even without further reaction according to claim 8.

20. Process according to any of claims 1 to 19, characterised in that the transition from metallic to reactive mode, with regard to its position and/or course, can be adjusted by the applied alternating current signal, its power and/or frequency.

21. Coating system for performance of the process according to any of claims 1 to 20, comprising a cathode switched, ohmically conductive target arrangement (12, 14), an anode arrangement (10,18) and an electric source (16) over the anode and the cathode arrangement, to generate a glow discharge between the cathode arrangement and the anode arrangement, an object holder (11) and at least one inlet arrangement (20, 32) for a gas into the chamber (A) between the workpiece (13) and the target arrangement (14), also with means (22, 28, 32a) which keep the coating process in an inherently unstable transition mode, where the source (16) emits direct current (DC) with overlaid alternating current (AC), characterised in that the source (16) emits an alternating current (AC) with a power-related dominant spectrum part of between 10 Hz and 250 kHz (inclusive).

22. System according to claim 21, characterised in that the dominant spectrum part lies between 50 Hz and 250 kHz, preferably between 10 kHz and 200 kHz (inclusive).

23. System according to claim 21 or 22, characterised in that the means comprise a fast control circuit for the process.

24. System according to any of claims 21 to 23, characterised in that at least one measurement value sensor (22) is provided which assesses at least one measurement value relevant to the process working point, that its output is passed to a comparison unit (28) which is supplied by a preset unit (30) with a nominal value (W) corresponding to the measurement value, that the output from the comparison unit ($\Delta$) acts as a control on a actuator arrangement (32a) influencing the process working point, and that the amplification of the open control circuit is essentially greater than 1 up to frequencies with which disturbance variables (S) affecting the working point can intervene in the process.

25. System according to any of claims 21 to 24, characterised in that actuators (16, 32a) for adjusting the operating working point, in particular for the reactive gas, are or can be set such that the system works in unstable transition mode (UM).

26. System according to claim 25, characterised in that the actuators are or can be set such that the system works in the vicinity of the metallic mode (MM).

27. System according to any of claims 25 or 26, characterised in that the actuators are or can be set such that the system generates a coating, the energy recovery ratio of which, given by the layer volume of the layer per sputtering energy used to the volume of a layer of target material per sputtering energy used for this, is $\geq 1$ preferably $> 1$, that preferably the target is essentially a target consisting of Si, that a gas supply (20) is connected to an $O_2$ reservoir and the $SiO_2$ layer generated has an energy recovery ratio of $\geq 1.2$.

28. System according to any of claims 21 to 27, characterised in that the following are provided as at least one actual value sensor of the control circuit:

- an optical sensor device, in particular an absorption and/or emission and/or fluorescence spectroscopy device and/or a plasma or light detection device and/or a discharge impedance measuring device and/or a partial pressure measuring device and/or a plasma monitor such as sold by the applicant.

29. System according to any of claims 21 to 28, characterised in that the target arrangement (12, 14) comprises a phosphorus-doped target, preferably an Si target, drawn or cast monocrystalline.

30. System according to any of claims 21, to 29, characterised in that at least one actuator (16, 32a) is provided on the control circuit for:

- the direct current signal and/or

- power and/or frequency of the alternating current signal and/or

- power ratio of direct and alternating current signals and/or

- reactive gas mass flow.

**31.** System according to any of claims 21 to 30, characterised in that the alternating current part is generated by a semiconductor generator.

**32.** System according to any of claims 21 to 31, characterised in that the carrier is stationary or moved occasionally.

**33.** System according to any of claims 21 to 32, characterised in that a rotating drive unit acts on the carrier (11) with a rotation frequency ($\omega$) essentially lower than that of a power-related dominant spectrum part of the alternating current signal (AC), preferably with a rotation frequency $\leq$ 1 Hz.

**34.** System according to any of claims 21 to 33, characterised in that a device is provided, preferably separate from the cathode and anode arrangement, in order to bring about, preferably by means of further supplied energy, a further reaction of the coating in a gas atmosphere.

**35.** System according to claim 34, characterised in that on the device are arranged means, such as an ion source and/ or a UV source and/or a laser device, a plasma source and electron source, a light source, a heating device such as an HF or microwave emitter.

**36.** System according to any of claims 21 to 34, characterised in that the target material (14) has a conductivity of 0.01 to 100 $\Omega$cm (both inclusive), preferably 0.01 to 1 $\Omega$cm (both inclusive).

**Revendications**

**1.** Procédé pour revêtir au moins un objet à l'aide d'au moins une couche, selon lequel une cible présentant une conductivité ohmique est pulvérisée dans une décharge lumineuse générée à l'aide d'un courant continu et d'un courant alternatif superposé, et les particules pulvérisées sont amenées en réaction avec un gaz dans l'espace défini entre la cible et une pièce à traiter et se déposent sur la pièce, le processus de revêtement étant réalisé dans le mode transitoire instable entre les modes métallique et réactif, et la couche étant plus mauvaise conductrice d'électricité que le matériau de la cible, caractérisé en ce que le courant alternatif présente une part spectrale dominante, en matière de puissance, située entre 10 Hz et 250 kHz (inclus).

**2.** Procédé selon la revendication 1, caractérisé en ce que la part spectrale dominante est située entre 50 Hz et 250 kHz, et de préférence entre 10 kHz et 200 kHz (inclus).

**3.** Procédé selon la revendication 1 ou 2, caractérisé en ce que le rapport de rendement énergétique, défini par le volume de la couche par énergie de pulvérisation mise en oeuvre, par rapport au volume d'une couche du matériau de cible déposée par voie non réactive par énergie de pulvérisation mise en oeuvre à cet effet est $\geq$ 1, de préférence > 1.

**4.** Procédé selon l'une des revendications 1 à 3, caractérisé en ce que le processus, dans le mode transitoire instable, est stabilisé par une régulation.

**5.** Procédé selon l'une des revendications 1 à 4, caractérisé en ce que le processus de revêtement est stabilisé dans le mode transitoire instable à proximité du passage vers le mode métallique.

**6.** Procédé selon l'une des revendications 1 à 5, caractérisé en ce qu'on utilise comme grandeur de réglage, dans un circuit régulateur de point de fonctionnement de processus, le signal de courant continu et/ou la fréquence et/ ou l'amplitude du signal de courant alternatif, et/ou le rapport de la puissance de courant continu à la puissance de courant alternatif et/ou le flux de masse de gaz réactif, et l'enregistrement de valeurs réelles se fait de préférence grâce à un procédé optique, en particulier grâce à une spectroscopie par absorption et/ou émission et/ou fluorescence de l'émission lumineuse de plasma et/ou grâce à un enregistrement de l'impédance de décharge et/ou de la pression partielle de gaz et/ou à l'aide d'un moniteur de plasma comme ceux qui sont commercialisés par exemple par la société Balzers AG, Balzers, FL.

7.  Procédé selon l'une des revendications 1 à 6, caractérisé en ce qu'on enregistre le point de fonctionnement du processus sous la forme d'un état ou d'une valeur réels à l'aide de techniques de mesure, on le compare à un état ou à une valeur de consigne et on intervient dans le processus en fonction du résultat de la comparaison, par l'intermédiaire d'au moins un actionneur, sous la forme d'une régulation du point de fonctionnement, et en ce que l'amplification du circuit régulateur ouvert est nettement supérieure à 1, au moins jusqu'à des fréquences de grandeurs perturbatrices qui interviennent dans le processus et influencent nettement le point de fonctionnement de celui-ci.

8.  Procédé selon l'une des revendications 2 à 7, caractérisé en ce que le revêtement est soumis à une réaction ultérieure supplémentaire.

9.  Procédé selon la revendication 8, caractérisé en ce que la réaction ultérieure est au moins renforcée dans un gaz et par un apport supplémentaire d'énergie comme par exemple de l'énergie lumineuse, de l'énergie de particules, ionique ou électronique, de l'énergie thermique, de l'énergie de plasma, de micro-ondes ou haute fréquence, et elle a lieu dans la ou une décharge lumineuse et/ou à l'extérieur de celle-ci.

10.  Procédé selon l'une des revendications 1 à 9, caractérisé en ce que l'objet prévu pour le revêtement est stationnaire ou déplacé au moins temporairement.

11.  Procédé selon l'une des revendications 1 à 10, caractérisé en ce que l'objet est déplacé sur une trajectoire circulaire avec une fréquence de rotation située nettement au-dessous de la part spectrale dominante du courant alternatif, de préférence avec une fréquence de rotation $\leq$ 1 Hz.

12.  Procédé selon l'une des revendications 1 à 11, caractérisé en ce que la courbe caractéristique de processus est commandée, et notamment aplatie, entre le mode métallique et réactif à l'aide de la part de courant alternatif.

13.  Procédé selon l'une des revendications 1 à 12, caractérisé en ce que la part de courant alternatif comporte au moins deux raies spectrales de fréquence ou un spectre continu.

14.  Procédé selon l'une des revendications 1 à 13, caractérisé en ce que la part de courant alternatif est générée par un générateur formé de semi-conducteurs.

15.  Procédé selon l'une des revendications 1 à 14, caractérisé en ce que la cible est une cible en Si dopée.

16.  Procédé selon l'une des revendications 1 à 15, caractérisé en ce que la cible présente une conductivité de 0,01 à 100 $\Omega$cm (inclus), de préférence de 0,01 à 1 $\Omega$cm (inclus).

17.  Procédé selon l'une des revendications 1 à 16, caractérisé en ce que la cible est une cible, de préférence en Si, dopée avec du phosphore et réalisée de manière monocristalline par étirage, ou coulée.

18.  Procédé selon l'une des revendications 1 à 17, caractérisé en ce que la cible est une cible en Si ou Al et la couche est une couche de $Al_2O_3$, de $SiO_2$ ou de $Si_3N_4$.

19.  Procédé selon l'une des revendications 1 à 18, caractérisé en ce que la cible est une cible en Si, de préférence dopée avec du phosphore, et la couche est en $SiO_2$, étant précisé que le rapport de rendement énergétique, qui est défini comme le volume de couche par énergie de pulvérisation mise en oeuvre, par rapport au volume d'une couche de Si déposée par énergie de pulvérisation de métal mise en oeuvre à cet effet, est $\geq$ 1,2, déjà sans la réaction ultérieure selon la revendication 8.

20.  Procédé selon l'une des revendications 1 à 19, caractérisé en ce que le passage du mode métallique au mode réactif peut être réglé, en ce qui concerne sa position et/ou sa courbe, grâce au signal de courant alternatif appliqué, à sa puissance et/ou à sa fréquence.

21.  Installation de revêtement pour la mise en oeuvre du procédé selon l'une des revendications 1 à 20, comprenant un dispositif formant cible (12, 14) monté comme une cathode et présentant une conductivité ohmique, un dispositif d'anode (10, 18) et une source électrique (16), sur le dispositif d'anode et de cathode, destinée à générer une décharge lumineuse entre le dispositif de cathode et le dispositif d'anode, ainsi qu'un porte-pièces (11), au moins un dispositif d'admission (20, 32) pour amener un gaz dans l'espace (A) défini entre la pièce (13) et le dispositif formant cible (14), et enfin des moyens (22, 28, 32a) qui maintiennent le processus de revêtement dans le mode transitoire instable en soi, la source (16) émettant un courant continu (CC) avec un courant alternatif (CA) superposé, caractérisée en ce que la source (16) émet un courant alternatif (CA) avec une part spectrale dominante, en matière de puissance, située entre 10 Hz et 250 kHz (inclus).

**22.** Installation selon la revendication 21, caractérisée en ce que la part spectrale dominante est située entre 50 Hz et 250 kHz, de préférence entre 10 kHz et 200 kHz (inclus).

**23.** Installation selon la revendication 21 ou 22, caractérisée en ce que les moyens comportent un circuit régulateur rapide pour le processus.

**24.** Installation selon l'une des revendications 21 à 23, caractérisée en ce qu'il est prévu au moins un capteur de valeurs de mesure (22) qui enregistre au moins une valeur de mesure importante pour le point de fonctionnement de processus, en ce que la sortie du capteur (22) est reliée à une unité de comparaison (28) à laquelle une valeur de consigne (W) correspondant à la valeur de mesure est transmise à partir d'une unité de prédéfinition (30), en ce que la sortie de l'unité de comparaison ($\Delta$) agit dans le sens d'une régulation sur un dispositif formant actionneur (32a) qui influence le point de fonctionnement de processus, et en ce que l'amplification du circuit régulateur ouvert est nettement supérieure à 1 jusqu'à des fréquences avec lesquelles des grandeurs perturbatrices (S) influençant le point de fonctionnement interviennent dans le processus.

**25.** Installation selon l'une des revendications 21 à 24, caractérisée en ce que les actionneurs (16, 32a) prévus pour le réglage du point de fonctionnement, en particulier pour le gaz réactif, sont réglés ou aptes à être réglés pour que l'installation fonctionne dans le mode transitoire (UM) instable.

**26.** Installation selon la revendication 25, caractérisée en ce que les actionneurs sont réglés ou aptes à être réglés pour que l'installation fonctionne à proximité du mode métallique (MM).

**27.** Installation selon la revendication 25 ou 26, caractérisée en ce que les actionneurs sont réglés ou aptes à être réglés pour que l'installation produise un revêtement dont le rapport de rendement énergétique, défini comme le volume de la couche par énergie de pulvérisation mise en oeuvre, par rapport au volume d'une couche en matériau cible par énergie de pulvérisation mise en oeuvre à cet effet, soit $\geq 1$, de préférence $> 1$, en ce que la cible est de préférence une cible composée essentiellement de Si et en ce qu'une amenée de gaz (20) est reliée à une réserve de $O_2$ et la couche de $SiO_2$ produite présente un rapport de rendement énergétique $\geq 1,2$.

**28.** Installation selon l'une des revendications 21 à 27, caractérisée en ce qu'il est prévu, pour le ou les capteurs de valeurs réelles du circuit régulateur :

- un dispositif formant capteur optique, en particulier un dispositif de spectroscopie par absorption et/ou émission et/ou fluorescence et/ou un dispositif d'enregistrement de plasma ou de lumière et/ou un dispositif de mesure d'impédance de décharge et/ou un dispositif de mesure de pression partielle et/ou un moniteur de plasma comme ceux qui sont commercialisés par la demanderesse.

**29.** Installation selon l'une des revendications 21 à 28, caractérisée en ce que le dispositif formant cible (12, 14) comporte une cible, de préférence en Si, dopée avec du phosphore, qui est monocristalline ou coulée.

**30.** Installation selon l'une des revendications 21 à 29, caractérisée en ce qu'il est prévu au niveau du circuit régulateur au moins un actionneur (16, 32a) pour :

- le signal de courant continu et/ou
- la puissance et/ou la fréquence du signal de courant alternatif et/ou
- le rapport de puissance du signal de courant continu et de courant alternatif et/ou
- le flux de masse de gaz réactif.

**31.** Installation selon l'une des revendications 21 à 30, caractérisée en ce que la part de courant alternatif est générée à l'aide d'un générateur formé de semi-conducteurs.

**32.** Installation selon l'une des revendications 21 à 31, caractérisée en ce que le porte-pièces est stationnaire ou entraîné temporairement.

**33.** Installation selon l'une des revendications 21 à 32, caractérisée en ce qu'un entraînement rotatif agit sur le porte-pièces (11) avec une fréquence de rotation ($\omega$), nettement inférieure à celle d'une part spectrale dominante, en matière de puissance, du signal de courant alternatif (CA), de préférence avec une fréquence de rotation $\leq$ 1 Hz.

**34.** Installation selon l'une des revendications 21 à 33, caractérisée en ce qu'il est prévu un dispositif, de préférence décalé par rapport au dispositif de cathode et d'anode, pour soumettre le revêtement à une réaction ultérieure dans une atmosphère gazeuse, de préférence à l'aide d'un apport supplémentaire d'énergie.

**35.** Installation selon la revendication 34, caractérisée en ce qu'il est prévu, au niveau du dispositif, des moyens tels qu'une source ionique et/ou une source d'UV et/ou un dispositif laser, une source de plasma, une source électronique, une source lumineuse, un dispositif de chauffage tel qu'un émetteur haute fréquence ou à micro-ondes.

**36.** Installation selon l'une des revendications 21 à 34, caractérisée en ce que le matériau cible (14) présente une conductivité de 0,01 à 100 $\Omega$cm (inclus) de préférence de 0,01 à 1 $\Omega$cm (inclus).

FIG.1

FIG.2

FIG. 3a

FIG. 3b

Si- Sputterkennlinie I (m*02); U (m*02) ≠ 349;

I wurde mit PEMO 4 von Metallmode bis

Reaktivmode in 2% Schritten verstellt

Intensität I in %  —Targetspannung Usb in V

O2 Fluss in sccm

—•—I(m*O₂)    —+—Usb(m*O₂)

I = I_{SI}

FIG. 4a

EP 0 508 359 B1

Intensität I in%          O2 Überschussdruck in E-3 mbar   P

02 Fluss in sccm

I(m 0)    U (m 0)

I=I_{SI}

FIG. 4b

EP 0 508 359 B1